(19) Europäisches Patentamt / European Patent Office / Office européen des brevets

(11) **EP 4 503 643 A1**

(12) **EUROPEAN PATENT APPLICATION**
published in accordance with Art. 153(4) EPC

(43) Date of publication:
**05.02.2025 Bulletin 2025/06**

(21) Application number: **23779870.7**

(22) Date of filing: **20.03.2023**

(51) International Patent Classification (IPC):
**H04N 25/705** (2023.01)    **G01S 7/481** (2006.01)
**G01S 17/894** (2020.01)

(52) Cooperative Patent Classification (CPC):
**G01S 7/481; G01S 17/894; H04N 25/705**

(86) International application number:
**PCT/JP2023/010993**

(87) International publication number:
**WO 2023/189854 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.03.2022 JP 2022053093**

(71) Applicant: **Nuvoton Technology Corporation Japan**
**Nagaokakyo City, Kyoto 617-8520 (JP)**

(72) Inventors:
• **KAWAMURA, Hideki**
  **Nagaokakyo City, Kyoto 617-8520 (JP)**
• **SUMITANI, Norihiko**
  **Nagaokakyo City, Kyoto 617-8520 (JP)**
• **OHTANI, Yutaka**
  **Nagaokakyo City, Kyoto 617-8520 (JP)**
• **ABE, Tetsuya**
  **Nagaokakyo City, Kyoto 617-8520 (JP)**

(74) Representative: **Novagraaf International SA**
**Chemin de l'Echo 3**
**1213 Onex, Geneva (CH)**

(54) **DISTANCE-MEASUREMENT IMAGING ELEMENT, PACKAGE, MODULE, AND DISTANCE-MEASUREMENT IMAGING DEVICE**

(57)    A depth imaging device (30) includes: a plurality of delay adjustment circuits (61, 62) that adjust a delay time of each of a plurality of control signals that control a plurality of gate electrodes (6a, 6b) of a plurality of pixels (40) and output a plurality of delayed control signals with adjusted delay times; and a plurality of drivers (51, 52) that receive input of the plurality of delayed control signals and output a plurality of drive signals that drive the plurality of gate electrodes (6a, 6b) of the plurality of pixels (40).

FIG. 2

EP 4 503 643 A1

## Description

[Technical Field]

The present disclosure relates to a depth imaging device, a package, a module, and a depth imaging system for measuring depth.

[Background Art]

Conventionally, depth imaging devices for measuring depth using an indirect time of flight (TOF) method are known (see, for example, Patent Literature (PTL) 1, PTL 2, and PTL 3).

[Citation List]

[Patent Literature]

[PTL 1] WO 2020/129954
[PTL 2] Japanese Unexamined Patent Application Publication No. 2019-75826
[PTL 3] Japanese Unexamined Patent Application Publication No. 2020-85464

[Summary of Invention]

[Technical Problem]

It is desirable to measure depth accurately.
The present disclosure has an object to provide a depth imaging device, a package, a module, and a depth imaging system capable of accurately measuring depth.

[Solution to Problem]

A depth imaging device according to one aspect of the present disclosure is for measuring depth using an indirect time of flight (TOF) method, and includes: a pixel array in which a plurality of pixels are arranged in an array, each of the plurality of pixels including a photoelectric converter that converts received light into charge, and a plurality of gate electrodes for transferring the charge generated by the photoelectric converter; a control signal output circuit that outputs a plurality of control signals that control the plurality of gate electrodes of the plurality of pixels; a plurality of delay adjustment circuits that adjust a delay time of each of the plurality of control signals and output a plurality of delayed control signals with adjusted delay times; a plurality of drivers that receive input of the plurality of delayed control signals and output a plurality of drive signals that drive the plurality of gate electrodes of the plurality of pixels; a plurality of power supply wirings that supply a power supply potential to the plurality of drivers; and a plurality of ground wirings that supply a ground potential to the plurality of drivers. The plurality of power supply wirings include a common portion with each other, the plurality of ground wirings include a common portion with each other, and the plurality of delay adjustment circuits adjust the delay times of the plurality of control signals to make respective phase differences between the plurality of control signals and the plurality of drive signals constant.

A package according to one aspect of the present disclosure includes the depth imaging device. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to a first set of two internal power supply terminals from among the first internal power supply terminal, the second internal power supply terminal, the third internal power supply terminal, and the fourth internal power supply terminal; and a second external power supply terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to one internal power supply terminal in the first set; (2) an electrical path from the first external power supply terminal to an other internal power supply terminal in the first set; (3) an electrical path from the second external power supply terminal to one internal power supply terminal in the second set; and (4) an electrical path from the second external power supply terminal to an other internal power supply terminal in the second set.

A package according to one aspect of the present disclosure includes: the depth imaging device. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to the first internal power supply terminal; a second external power supply terminal connected to the second internal power supply terminal; a third external power supply terminal connected to the third internal power supply terminal; and a fourth external power supply terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to the first internal power supply terminal; (2) an electrical path from the second external power supply terminal to the second internal power supply terminal; (3) an electrical path from the third external power supply terminal to the third internal power supply terminal; and (4) an electrical path from the fourth external power supply terminal to the fourth internal power supply terminal.

A module according to one aspect of the present disclosure includes: the depth imaging device; and a mounting substrate on which the depth imaging device is mounted. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to a first set of two internal power supply terminals from among the first internal power supply terminal, the second internal power supply terminal, the third internal power supply terminal, and the fourth internal power supply terminal; and a second bypass capacitor including one terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to one internal power supply terminal in the first set; (2) an electrical path from the first bypass capacitor to an other internal power supply terminal in the first set; (3) an electrical path from the second bypass capacitor to one internal power supply terminal in the second set; and (4) an electrical path from the second bypass capacitor to an other internal power supply terminal in the second set.

A module according to one aspect of the present disclosure includes: the depth imaging device; and a mounting substrate on which the depth imaging device is mounted. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to the first internal power supply terminal; a second bypass capacitor including one terminal connected to the second internal power supply terminal; a third bypass capacitor including one terminal connected to the third internal power supply terminal; and a fourth bypass capacitor including one terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to the first internal power supply terminal; (2) an electrical path from the second bypass capacitor to the second internal power supply terminal; (3) an electrical path from the third bypass capacitor to the third internal power supply terminal; and (4) an electrical path from the fourth bypass capacitor to the fourth internal power supply terminal.

A package according to one aspect of the present disclosure includes a depth imaging device for measuring depth using an indirect time of flight (TOF) method. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to a first set of two internal power supply terminals from among the first internal power supply terminal, the second internal power supply terminal, the third internal power supply terminal, and the fourth internal power supply terminal; and a second external power supply terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to one internal power supply terminal in the first set; (2) an electrical path from the first external power supply terminal to an other internal power supply terminal in the first set; (3) an electrical path from the second external power supply terminal to one internal power supply terminal in the second set; and (4) an electrical path from the second external power supply terminal to an other internal power supply terminal in the second set.

A package according to one aspect of the present disclosure includes a depth imaging device for measuring depth using an indirect time of flight (TOF) method. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to the first internal power supply terminal; a second external power supply terminal connected to the second internal power supply terminal; a third external power supply terminal connected to the third internal power supply terminal; and a fourth external power supply terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to the first internal power supply terminal; (2) an electrical path from the second external power supply terminal to the second internal power supply terminal; (3) an electrical path from the third external power supply terminal to the third internal power supply terminal; and (4) an electrical path from the fourth external power supply terminal to the fourth internal power supply terminal.

A module according to one aspect of the present disclosure includes: a depth imaging device for measuring depth using an indirect time of flight (TOF) method; and a mounting substrate on which the depth imaging device is mounted. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to a first set of two internal power supply terminals from among the first internal power supply terminal, the second internal power supply terminal, the third internal power supply terminal, and the fourth internal power supply terminal; and a second bypass capacitor including one terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to one internal power supply terminal in the first set; (2) an electrical path from the first bypass capacitor to an other internal power supply terminal in the first set; (3) an electrical path from the second bypass capacitor to one internal power supply terminal in the second set; and (4) an electrical path from the second bypass capacitor to an other internal power supply terminal in the second set.

A module according to one aspect of the present disclosure includes: a depth imaging device for measuring depth using an indirect time of flight (TOF) method; and a mounting substrate on which the depth imaging device is mounted. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to the first internal power supply terminal; a second bypass capacitor including one terminal connected to the second internal power supply terminal; a third bypass capacitor including one terminal connected to the third internal power supply terminal; and a fourth bypass capacitor including one terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to the first internal power supply terminal; (2) an electrical path from the second bypass capacitor to the second internal power supply terminal; (3) an electrical path from the third bypass capacitor to the third internal power supply terminal; and (4) an electrical path from the fourth bypass capacitor to the fourth internal power supply terminal.

A depth imaging system according to one aspect of the present disclosure includes: the depth imaging device, the package, or the module.

[Advantageous Effects of Invention]

With the depth imaging device, package, module, and depth imaging system according to one aspect of the present disclosure, accurate depth measurement can be performed.

[Brief Description of Drawings]

[FIG. 1]

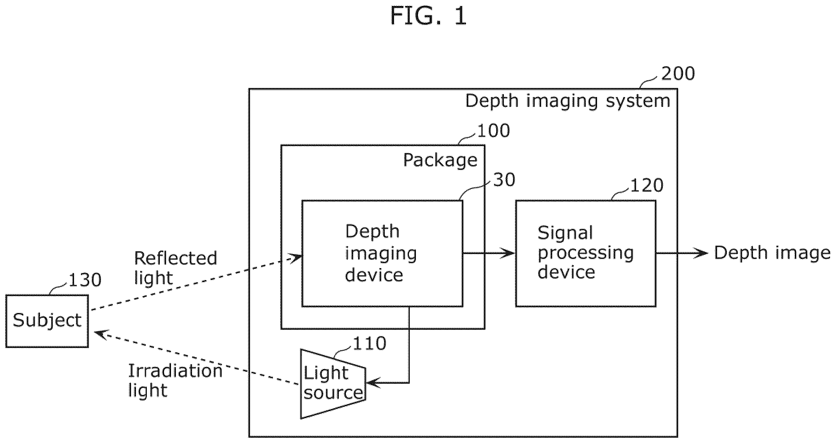

FIG. 1 is a functional block diagram illustrating a schematic configuration of a depth imaging system according to Embodiment 1.
[FIG. 2]

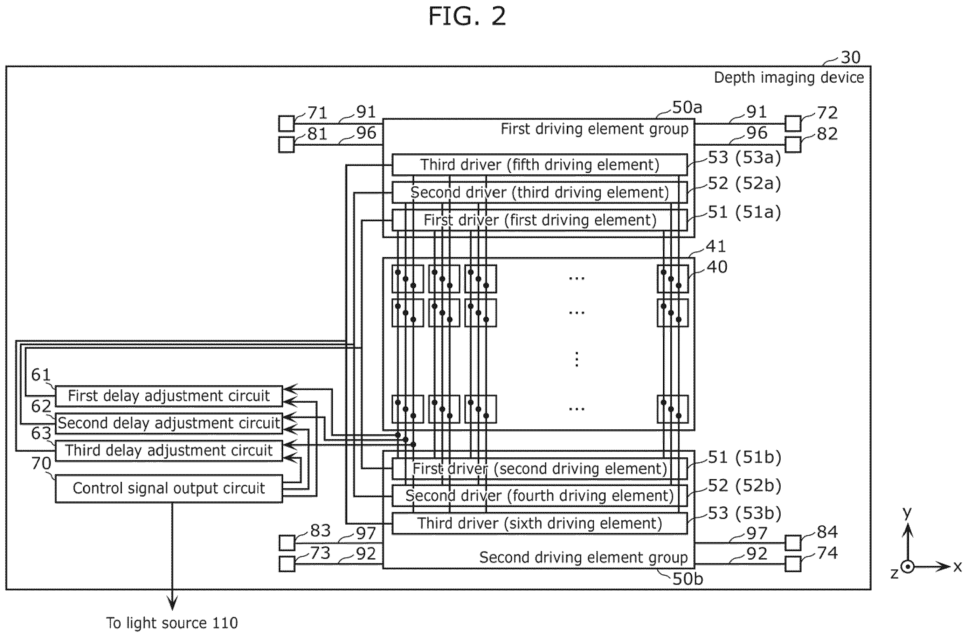

FIG. 2 is a circuit diagram illustrating a configuration of a depth imaging device according to Embodiment 1.
[FIG. 3]

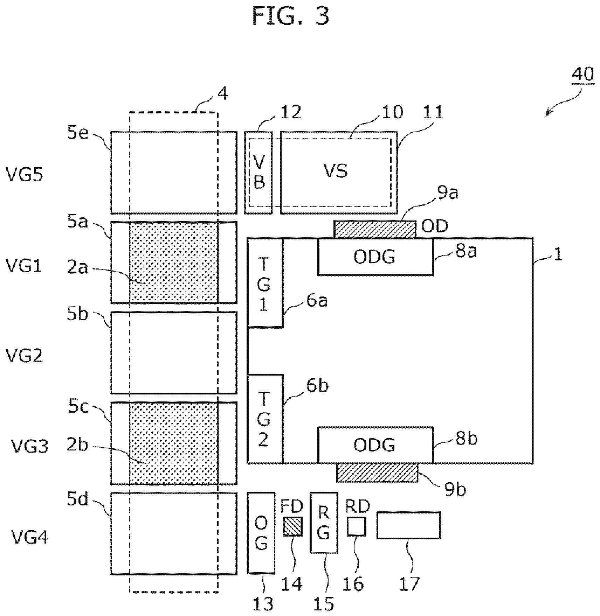

FIG. 3 is a schematic plan view illustrating a configuration of a pixel according to Embodiment 1.
[FIG. 4]

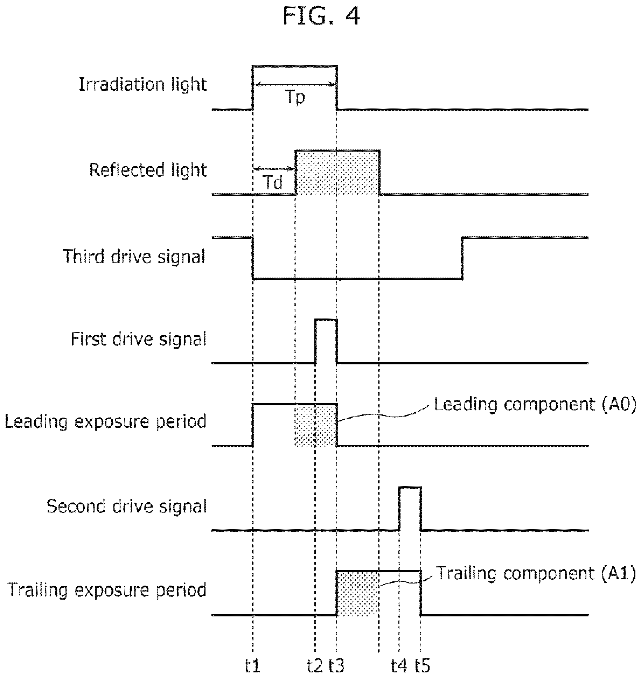

FIG. 4 is a timing chart illustrating operation of a pixel during exposure according to Embodiment 1.
[FIG. 5]

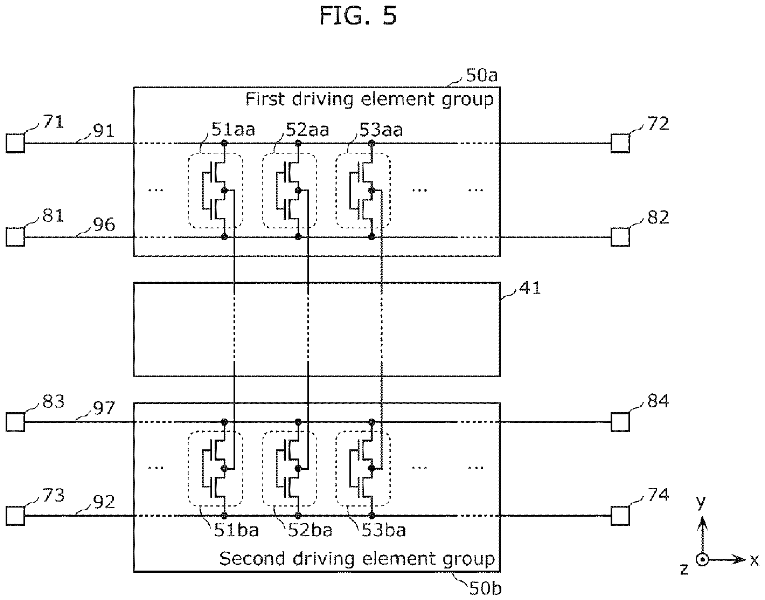

FIG. 5 is a schematic diagram illustrating a schematic configuration of a first driving element group and a second driving element group according to Embodiment 1.
[FIG. 6]

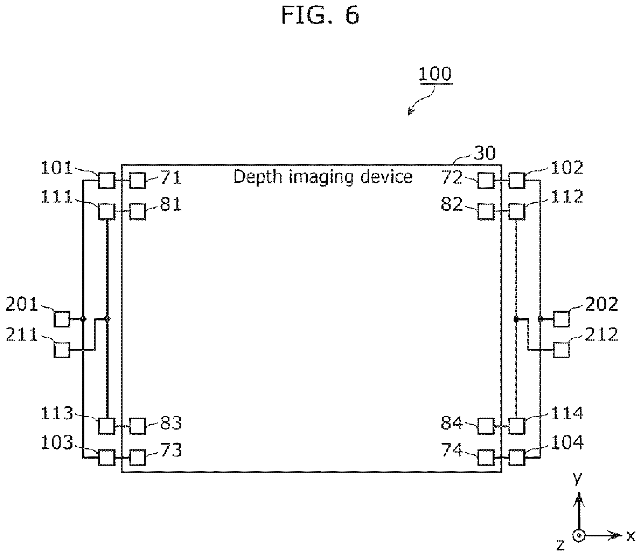

FIG. 6 is a schematic plan view illustrating a configuration of a package according to Embodiment 1.
[FIG. 7]

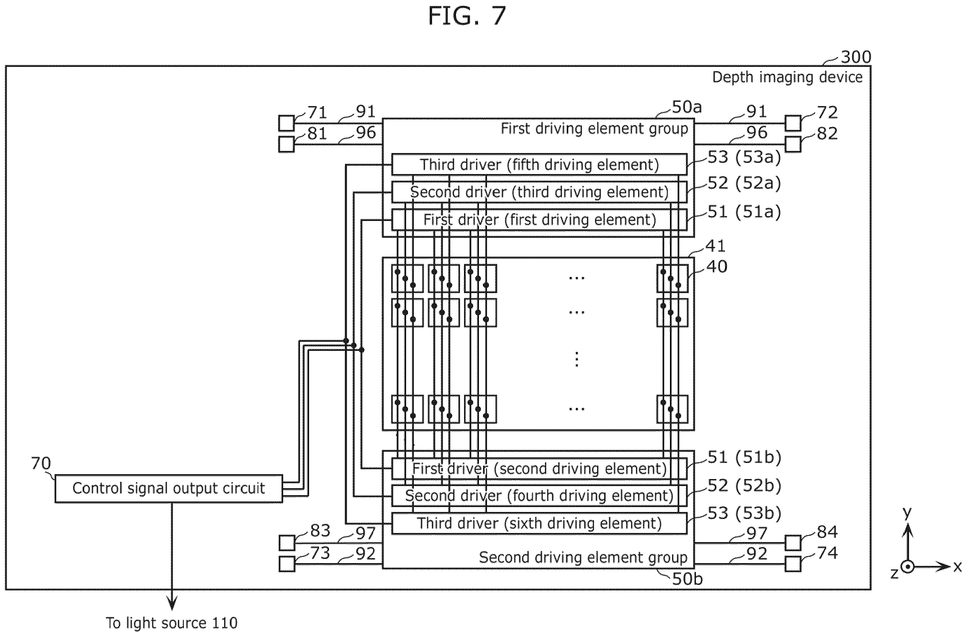

FIG. 7 is a circuit diagram illustrating a configuration of the depth imaging device according to Embodiment 1.
[FIG. 8]

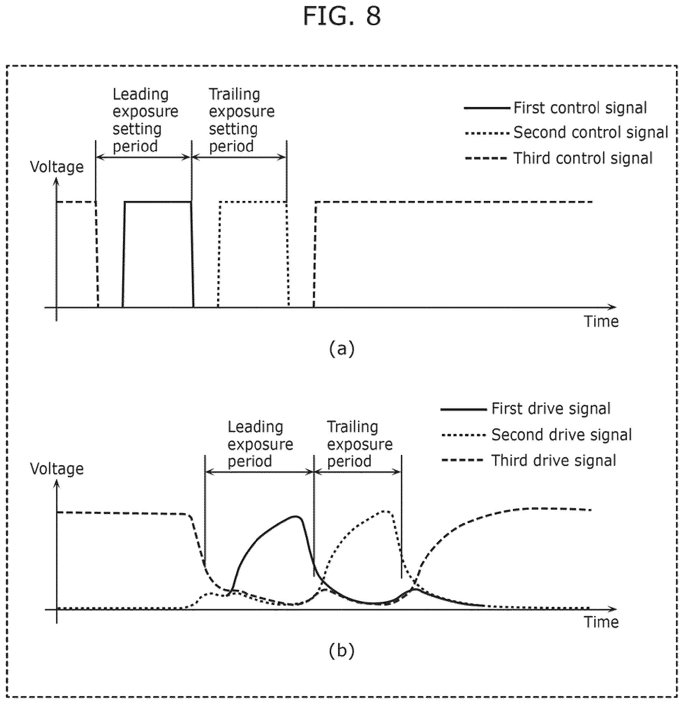

FIG. 8 is a waveform diagram in a simulation of operation of a first driver, a second driver, and a third driver according to Embodiment 1.
[FIG. 9]

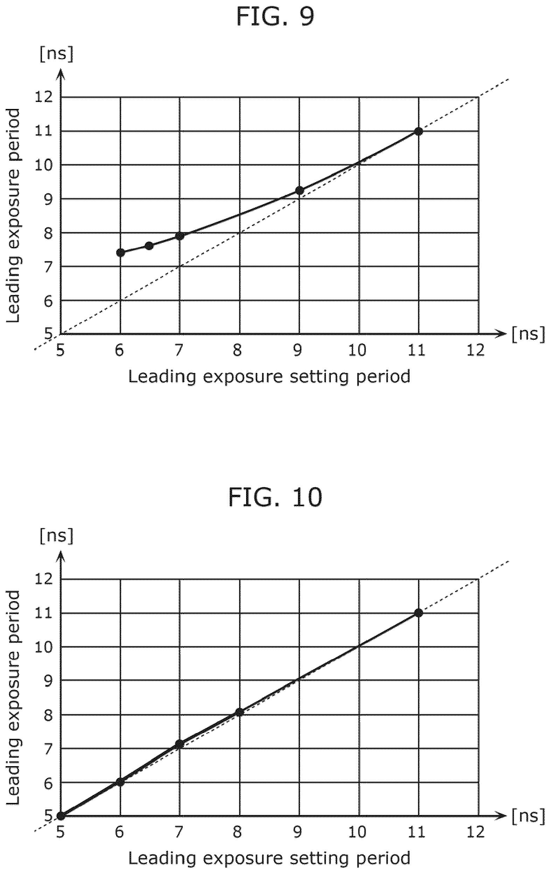

FIG. 9 is a graph illustrating the relationship between a leading exposure setting period and a leading exposure period according to Embodiment 1.
[FIG. 10]
FIG. 10 is a graph illustrating the relationship between the leading exposure setting period and the leading exposure period according to Embodiment 1.
[FIG. 11]

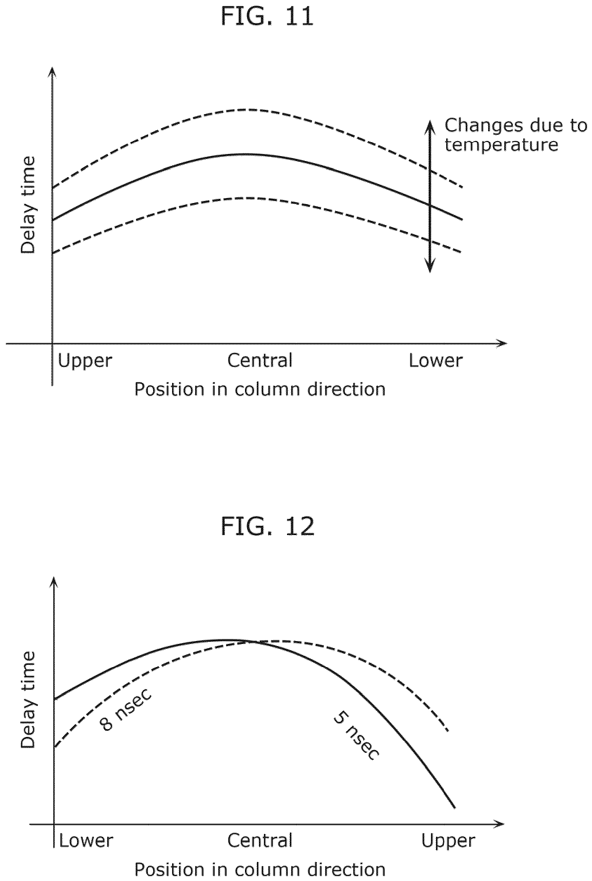

FIG. 11 is a graph illustrating a distribution of ideal delay times of drive signals with respect to positions in the column direction.
[FIG. 12]
FIG. 12 is a graph illustrating simulation results of the distribution of delay times of drive signals with respect to positions in the column direction under a first simulation condition.
[FIG. 13]

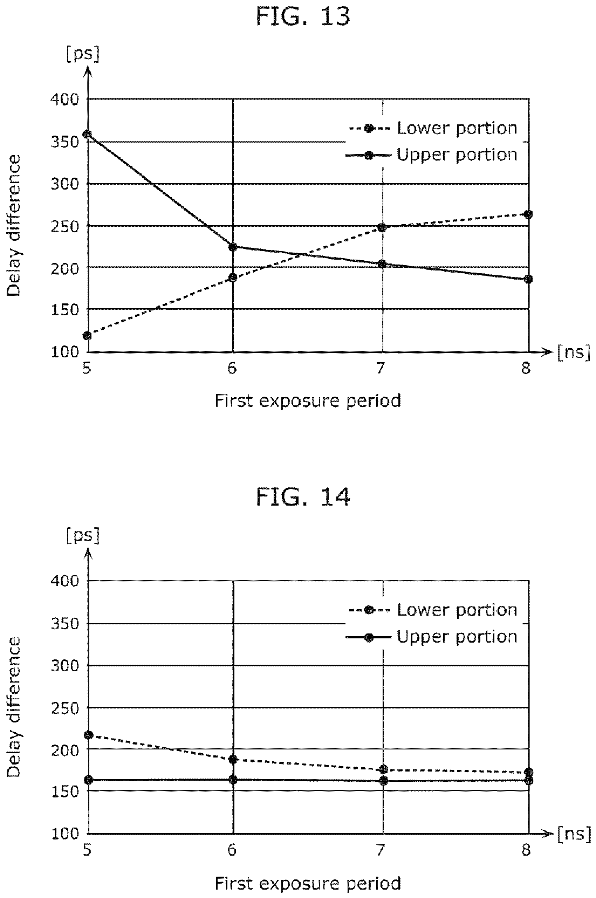

FIG. 13 is a graph illustrating the relationship between a first exposure period and delay difference under the first simulation condition.
[FIG. 14]
FIG. 14 is a graph illustrating the relationship between a first exposure period and delay difference under a second simulation condition.
[FIG. 15A]

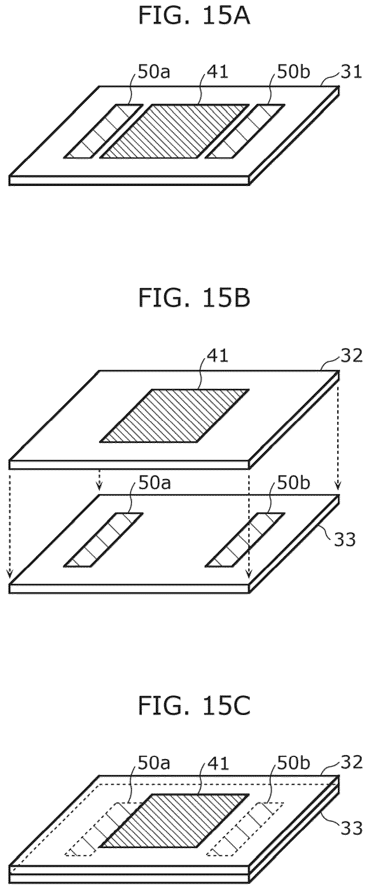

FIG. 15A is a perspective view of the depth imaging device according to Embodiment 1.
[FIG. 15B]
FIG. 15B is an exploded perspective view of the depth imaging device according to Embodiment 1.
[FIG. 15C]
FIG. 15C is a perspective view of the depth imaging device according to Embodiment 1.
[FIG. 16]

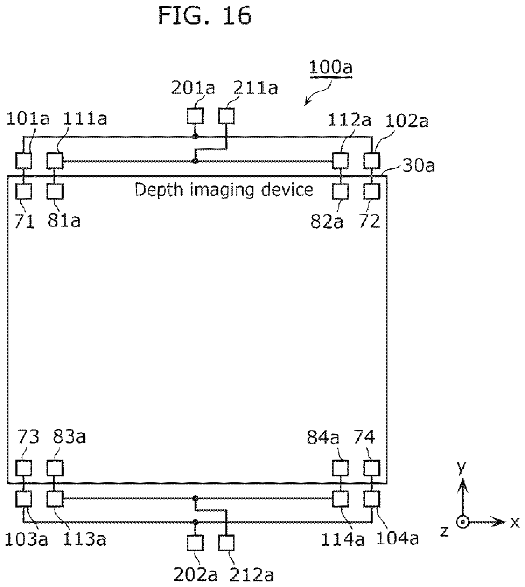

FIG. 16 is a schematic plan view illustrating a configuration of a package according to Variation 1.
[FIG. 17]

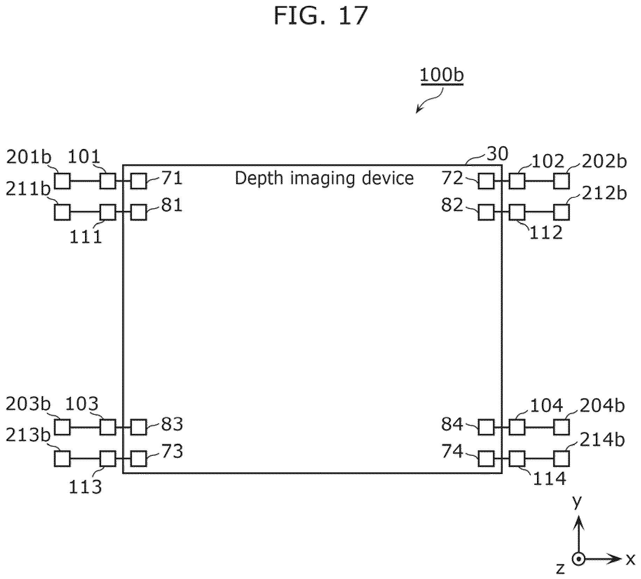

FIG. 17 is a schematic plan view illustrating a configuration of a package according to Variation 2.
[FIG. 18]

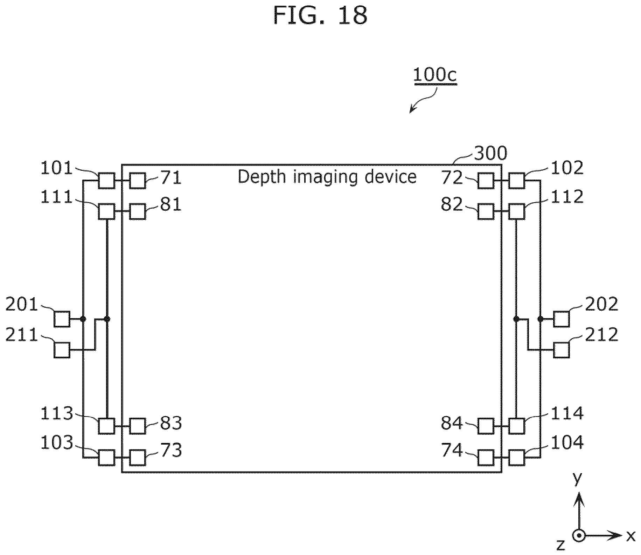

FIG. 18 is a schematic plan view illustrating a configuration of a package according to Variation 3.
[FIG. 19]

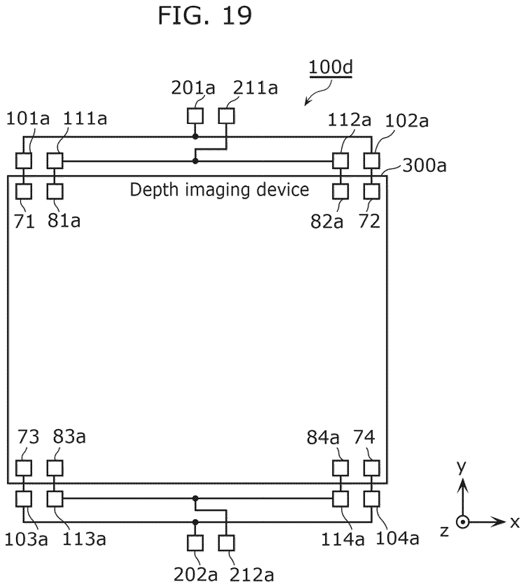

FIG. 19 is a schematic plan view illustrating a configuration of a package according to Variation 4.
[FIG. 20]

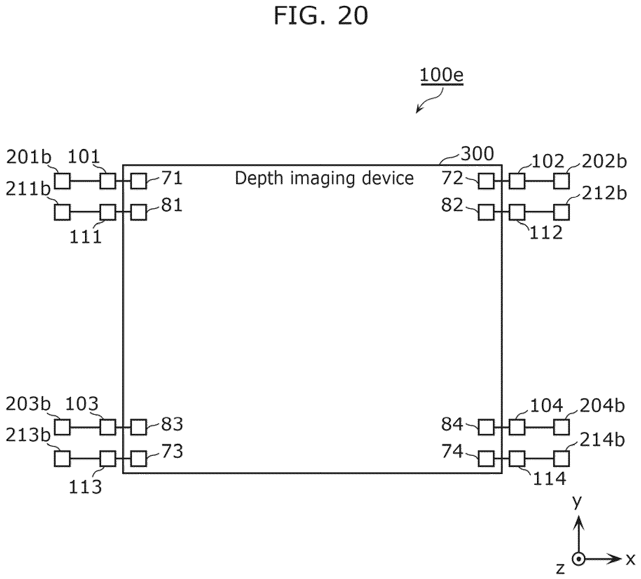

FIG. 20 is a schematic plan view illustrating a configuration of a package according to Variation 5.
[FIG. 21]

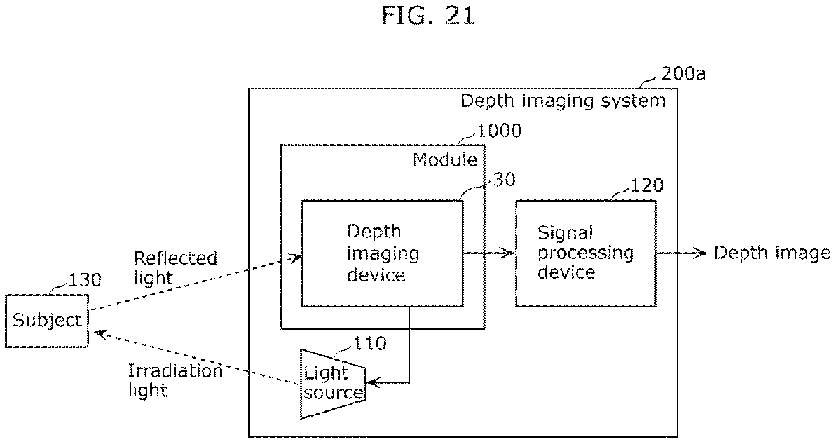

FIG. 21 is a functional block diagram illustrating a schematic configuration of a depth imaging system according to Embodiment 2.
[FIG. 22]

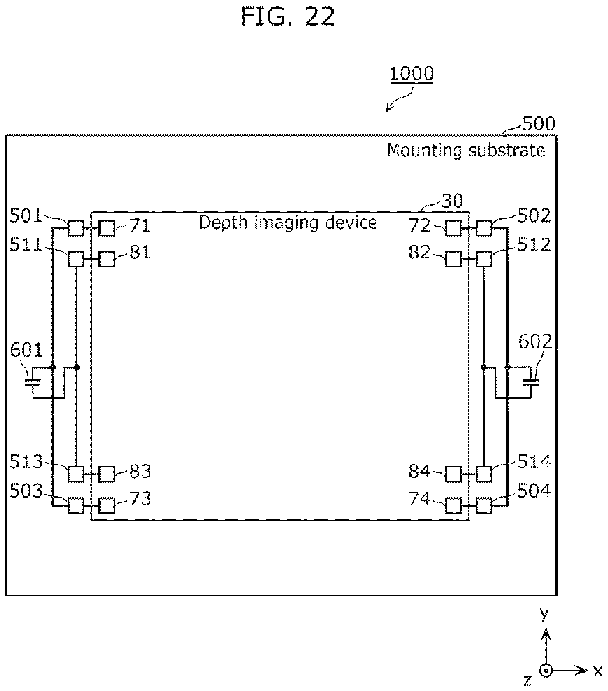

FIG. 22 is a schematic plan view illustrating a configuration of a module according to Embodiment 2.
[FIG. 23]

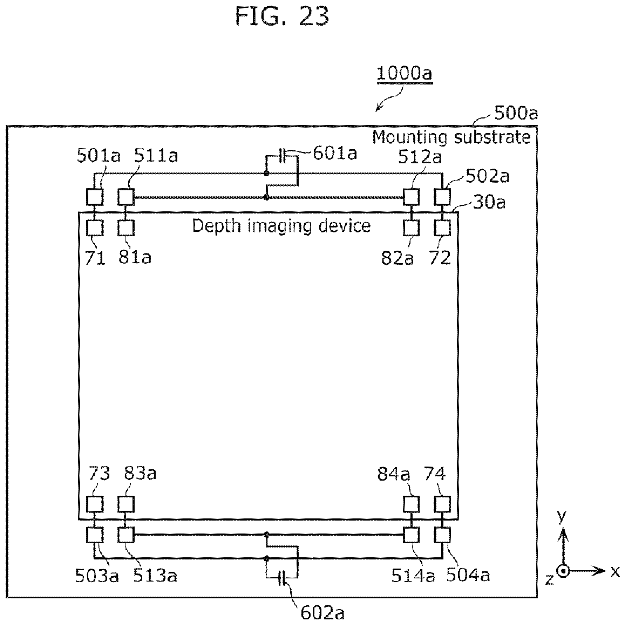

FIG. 23 is a schematic plan view illustrating a configuration of a module according to Variation 6.

[FIG. 24]

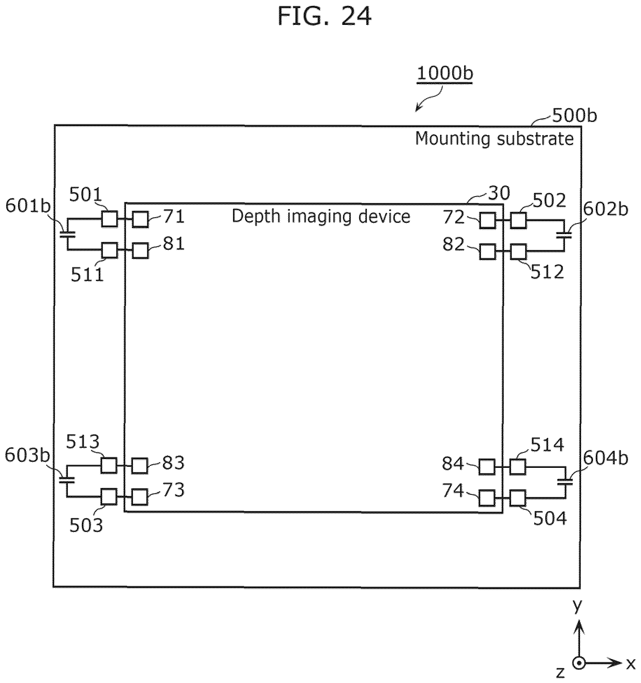

FIG. 24 is a schematic plan view illustrating a configuration of a module according to Variation 7.
[FIG. 25]

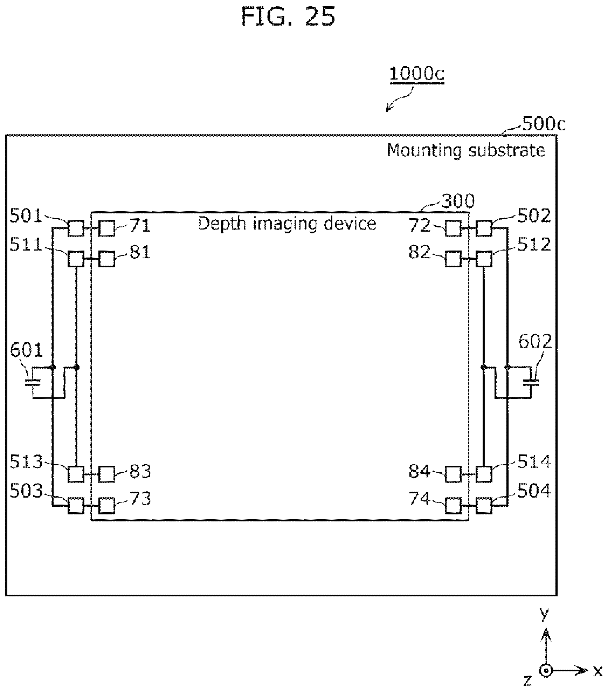

FIG. 25 is a schematic plan view illustrating a configuration of a module according to Variation 8.
[FIG. 26]

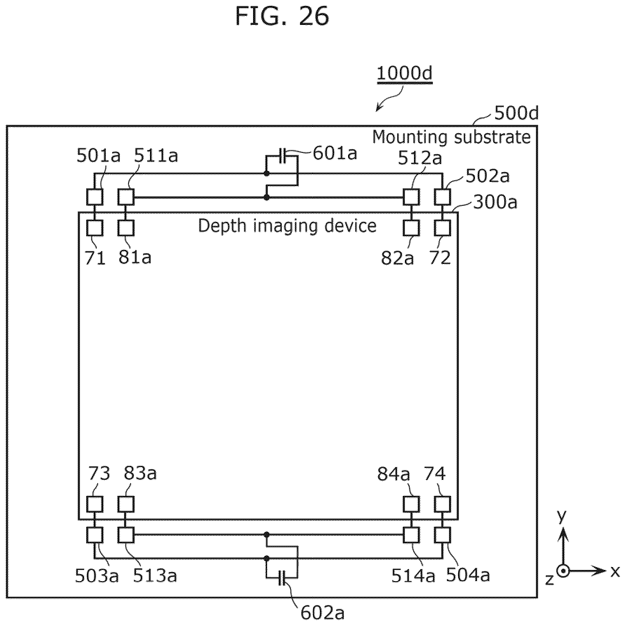

FIG. 26 is a schematic plan view illustrating a configuration of a module according to Variation 9.
[FIG. 27]

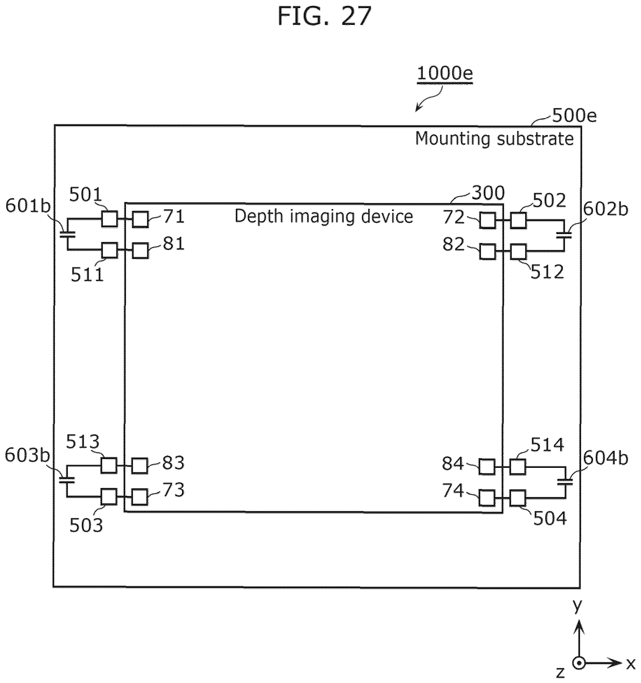

FIG. 27 is a schematic plan view illustrating a configuration of a module according to Variation 10.
[FIG. 28]

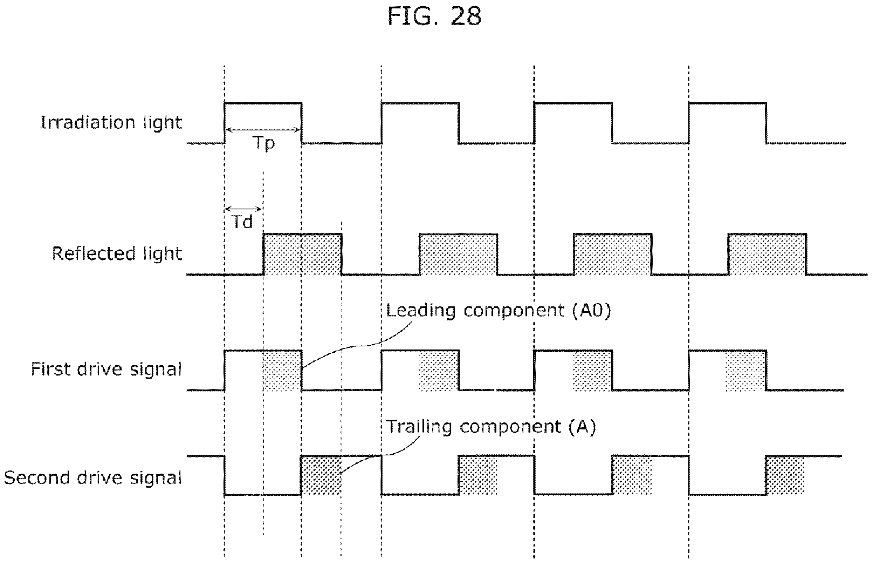

FIG. 28 is a timing chart illustrating another example of operation of the pixel during exposure according to Embodiment 1.
[FIG. 29]

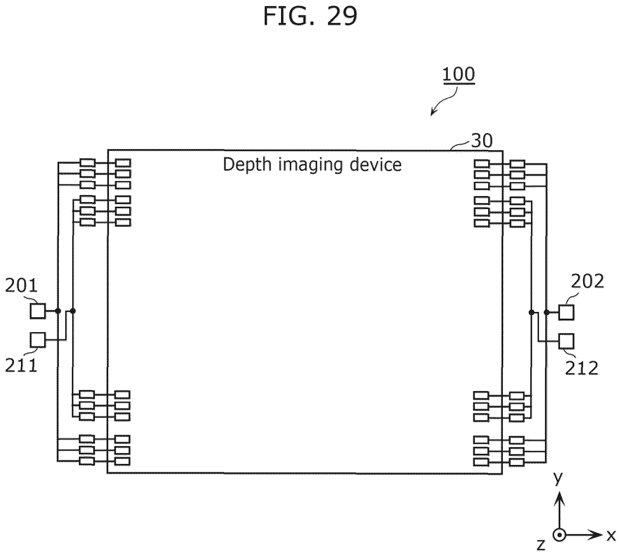

FIG. 29 is a schematic plan view illustrating another example of a configuration of the package according to Embodiment 1.

[Description of Embodiments]

(Underlying Knowledge Forming Basis of One Aspect of Present Disclosure)

The inventors conducted diligent experiments and investigations to improve the depth measurement accuracy in depth measurement that uses an indirect TOF method using a depth imaging device.
Through these experiments and investigations, the inventors identified causes of reduction in depth measurement accuracy.
Namely, the inventors found that when the electric potential of the power supply or the electric potential of the ground of the driver that drives the control signal defining the operation timing of a plurality of pixels included in the depth imaging device fluctuates, the operation timing of each pixel fluctuates, thereby reducing depth measurement accuracy.
The inventors also found that when the timing at which the control signal reaches the pixels fluctuates, if the amount of fluctuation in the timing at which the control signal reaches pixels differs between pixels at different physical positions, the operation timing between the pixels at the different physical positions fluctuates, thereby reducing depth measurement accuracy.
In view of this, the inventors continued further experiments and investigations to eliminate these factors causing a reduction in depth measurement accuracy.
As a result, the inventors arrived at the depth imaging device and the like according to the following present disclosure.
A depth imaging device according to one aspect of the present disclosure is for measuring depth using an indirect time of flight (TOF) method, and includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first delay adjustment circuit that adjusts a delay time of the first control signal and outputs a first delayed control signal with the adjusted delay time; a second delay adjustment circuit that adjusts a delay time of the second control signal and outputs a second delayed control signal with the adjusted delay time; a first driver that receives input of the first delayed control signal and outputs a first drive signal that drives the first gate electrodes of the plurality of pixels; a second driver that receives input of the second delayed control signal and outputs a second drive signal that drives the second gate electrodes of the plurality of pixels; a first power supply wiring that supplies a power supply potential to the first driver; a second power supply wiring that supplies the power supply potential to the second driver; a first ground wiring that supplies a ground potential to the first driver; and a second ground wiring that supplies the ground potential to the second driver. The first power supply wiring and the second power supply wiring include a common portion. The first ground wiring and the second ground wiring include a common portion. The first delay adjustment circuit adjusts the delay time of the first control signal to make a phase difference between the first control signal and the first drive signal constant. The second delay adjustment circuit adjusts the delay time of the second control signal to make a phase difference between the second control signal and the second drive signal constant.

With the depth imaging device configured as described above, the phase difference between the first control signal and the first drive signal, and the phase difference between the second control signal and the second drive signal are maintained constant. Therefore, even if the power supply potential or ground potential supplied to the first driver fluctuates and the delay time of the first driver fluctuates, or even if the power supply potential or ground potential supplied to the second driver fluctuates and the delay time of the second driver fluctuates, the operation timing of the first gate electrode and the operation timing of the second gate electrode in each pixel do not fluctuate.

Accordingly, accurate depth measurement can be performed with the depth imaging device configured as described above.

Each of the plurality of pixels may further include a third gate electrode for discharging the charge generated by the photoelectric converter. The control signal output circuit may further output a third control signal that controls the third gate electrodes of the plurality of pixels. The depth imaging device may further include: a third delay adjustment circuit that adjusts a delay time of the third control signal and outputs a third delayed control signal with an adjusted delay time; and a third driver that receives input of the third delayed control signal and outputs a third drive signal that drives the third gate electrodes of the plurality of pixels. The third delay adjustment circuit may adjust the delay time of the third control signal to make a phase difference between the third control signal and the third drive signal constant.

The control signal output circuit may output the first control signal including a pulse with a pulse width of 10 ns or less and the second control signal including a pulse with a pulse width of 10 ns or less.

The depth imaging device may be configured as: a single semiconductor chip on which the pixel array, the first driver, and the second driver are formed; or a first semiconductor chip on which the pixel array is formed and a second semiconductor chip on which the first driver and the second driver are formed, the first semiconductor chip and the second semiconductor chip being stacked on each other.

A package according to one aspect of the present disclosure includes the depth imaging device. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to a first set of two internal power supply terminals from among the first internal power supply terminal, the second internal power supply terminal, the third internal power supply terminal, and the fourth internal power supply terminal; and a second external power supply terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to one internal power supply terminal in the first set; (2) an electrical path from the first external power supply terminal to an other internal power supply terminal in the first set; (3) an electrical path from the second external power supply terminal to one internal power supply terminal in the second set; and (4) an electrical path from the second external power supply terminal to an other internal power supply terminal in the second set.

With the package configured as described above, the symmetry of the electrical characteristics of the electrical path supplying the power supply potential from the first or second external power supply terminal in the package to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the package configured as described above.

A package according to one aspect of the present disclosure includes: the depth imaging device. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to the first internal power supply terminal; a second external power supply terminal connected to the second internal power supply terminal; a third external power supply terminal connected to the third internal power supply terminal; and a fourth external power supply terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to the first internal power supply terminal; (2) an electrical path from the second external power supply terminal to the second internal power supply terminal; (3) an electrical path from the third external power supply terminal to the third internal power supply terminal; and (4) an electrical path from the fourth external power supply terminal to the fourth internal power supply terminal.

With the package configured as described above, the symmetry of the electrical characteristics of the electrical path supplying the power supply potential from the first, second, third, or fourth external power supply terminal in the package to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the package configured as described above.

A module according to one aspect of the present disclosure includes: the depth imaging device; and a mounting substrate on which the depth imaging device is mounted. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to a first set of two internal power supply terminals from among the first internal power supply terminal, the second internal power supply terminal, the third internal power supply terminal, and the fourth internal power supply terminal; and a second bypass capacitor including one terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to one internal power supply terminal in the first set; (2) an electrical path from the first bypass capacitor to an other internal power supply terminal in the first set; (3) an electrical path from the second bypass capacitor to one internal power supply terminal in the second set; and (4) an electrical path from the second bypass capacitor to an other internal power supply terminal in the second set.

With the module configured as described above, the symmetry of the electrical characteristics of the electrical path supplying the power supply potential from the first or second bypass capacitor on the mounting substrate to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the module configured as described above.

A module according to one aspect of the present disclosure includes: the depth imaging device; and a mounting substrate on which the depth imaging device is mounted. The first driver includes a first driving element and a second driving element arranged in positions opposing each other and sandwiching the pixel array in a first direction in a plan view of the depth imaging device. The depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to the first internal power supply terminal; a second bypass capacitor including one terminal connected to the second internal power supply terminal; a third bypass capacitor including one terminal connected to the third internal power supply terminal; and a fourth bypass capacitor including one terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to the first internal power supply terminal; (2) an electrical path from the second bypass capacitor to the second internal power supply terminal; (3) an electrical path from the third bypass capacitor to the third internal power supply terminal; and (4) an electrical path from the fourth bypass capacitor to the fourth internal power supply terminal.

With the module configured as described above, the symmetry of the electrical characteristics of the electrical path supplying the power supply potential from the first, second, third, or fourth bypass capacitor on the mounting substrate to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the module configured as described above.

A package according to one aspect of the present disclosure includes a depth imaging device for measuring depth using an indirect time of flight (TOF) method. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to a first set of two internal power supply terminals from among the first internal power supply terminal, the second internal power supply terminal, the third internal power supply terminal, and the fourth internal power supply terminal; and a second external power supply terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to one internal power supply terminal in the first set; (2) an electrical path from the first external power supply terminal to an other internal power supply terminal in the first set; (3) an electrical path from the second external power supply terminal to one internal power supply terminal in the second set; and (4) an electrical path from the second external power supply terminal to an other internal power supply terminal in the second set.

With the package configured as described above, the symmetry of the electrical characteristics of the electrical path supplying the power supply potential from the first or second external power supply terminal in the package to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the package configured as described above.

A package according to one aspect of the present disclosure includes a depth imaging device for measuring depth using an indirect time of flight (TOF) method. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The package further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to the first internal power supply terminal; a second external power supply terminal connected to the second internal power supply terminal; a third external power supply terminal connected to the third internal power supply terminal; and a fourth external power supply terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first external power supply terminal to the first internal power supply terminal; (2) an electrical path from the second external power supply terminal to the second internal power supply terminal; (3) an electrical path from the third external power supply terminal to the third internal power supply terminal; and (4) an electrical path from the fourth external power supply terminal to the fourth internal power supply terminal.

With the package configured as described above, the symmetry of the electrical characteristics of the electrical path supplying the power supply potential from the first, second, third, or fourth external power supply terminal in the package to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the package configured as described above.

A module according to one aspect of the present disclosure includes: a depth imaging device for measuring depth using an indirect time of flight (TOF) method; and a mounting substrate on which the depth imaging device is mounted. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to a first set of two internal power supply terminals from among the first internal power supply terminal, the second internal power supply terminal, the third internal power supply terminal, and the fourth internal power supply terminal; and a second bypass capacitor including one terminal connected to a second set of two internal power supply terminals not included in the first set from among the first internal power supply terminal, the second internal power supply terminal, the third internal power supply terminal, and the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to one internal power supply terminal in the first set; (2) an electrical path from the first bypass capacitor to an other internal power supply terminal in the first set; (3) an electrical path from the second bypass capacitor to one internal power supply terminal in the second set; and (4) an electrical path from the second bypass capacitor to an other internal power supply terminal in the second set.

With the module configured as described above, the symmetry of the electrical characteristics of the electrical path supplying the power supply potential from the first or second bypass capacitor on the mounting substrate to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the module configured as described above.

A module according to one aspect of the present disclosure includes: a depth imaging device for measuring depth using an indirect time of flight (TOF) method; and a mounting substrate on which the depth imaging device is mounted. The depth imaging device includes: a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver. The first power supply wiring and the second power supply wiring include a common part. The first ground wiring and the second ground wiring include a common portion. The first driver includes a first driving element and a second driving element arranged in positions opposing each other and sandwiching the pixel array in a first direction in a plan view of the depth imaging device. The depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element. The first power supply terminal and the second power supply terminal are arranged in positions opposing each other and sandwiching the first driving element in a second direction orthogonal to the first direction in the plan view of the depth imaging device. The third power supply terminal and the fourth power supply terminal are arranged in positions opposing each other and sandwiching the second driving element in the second direction in the plan view of the depth imaging device. The first ground terminal and the second ground terminal are arranged in positions opposing each other and sandwiching the first driving element in the second direction in the plan view of the depth imaging device. The third ground terminal and the fourth ground terminal are arranged in positions opposing each other and sandwiching the second driving element in the second direction in the plan view of the depth imaging device. The mounting substrate further includes: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to the first internal power supply terminal; a second bypass capacitor including one terminal connected to the second internal power supply terminal; a third bypass capacitor including one terminal connected to the third internal power supply terminal; and a fourth bypass capacitor including one terminal connected to the fourth internal power supply terminal. A difference in length between each of the following four electrical paths is less than or equal to 3 mm, or a difference in inductance between each of the following four electrical paths is less than or equal to 2 nH: (1) an electrical path from the first bypass capacitor to the first internal power supply terminal; (2) an electrical path from the second bypass capacitor to the second internal power supply terminal; (3) an electrical path from the third bypass capacitor to the third internal power supply terminal; and (4) an electrical path from the fourth bypass capacitor to the fourth internal power supply terminal.

With the module configured as described above, the symmetry of the electrical characteristics of the electrical path supplying the power supply potential from the first, second, third, or fourth bypass capacitor on the mounting substrate to the first or second driving element in the semiconductor element is maintained within a certain range. Therefore, even when the timing at which the control signal reaches the pixels fluctuates, the difference in the amount of fluctuation in the operation timing of the first gate electrode between pixels at different physical positions can be maintained within a certain range.

Accordingly, accurate depth measurement can be performed with the module configured as described above.

A depth imaging system according to one aspect of the present disclosure includes: the depth imaging device, the package, or the module.

With the depth imaging system configured as described above, depth measurement is performed using the depth imaging device, package, or module.

Accordingly, accurate depth measurement can be performed with the depth imaging system configured as described above.

Hereinafter, specific examples of a depth imaging device and the like according to one aspect of the present disclosure will be described with reference to the drawings. Each of the embodiments described below is one specific example of the present disclosure. Accordingly, the numerical values, shapes, elements, arrangement and connection of the elements, as well as steps (processes) and orders of the steps, etc. indicated in the following embodiments are merely examples, and do not intend to limit the present disclosure. Moreover, the figures are schematic illustrations and are not necessarily precise depictions. In the figures, elements that are essentially the same share the same reference signs, and repeated description may be omitted or simplified.

(Embodiment 1)

[Configuration]

FIG. 1 is a functional block diagram illustrating a schematic configuration of depth imaging system 200 according to Embodiment 1.

As illustrated in FIG. 1, depth imaging system 200 includes: package 100 including depth imaging device 30; light source 110; and signal processing device 120.

Light source 110 emits pulsed irradiation light toward subject 130.

Depth imaging device 30 receives reflected light of the irradiation light from subject 130, and outputs a signal based on the received reflected light.

Signal processing device 120 measures depth using an indirect TOF method based on the signal output from depth imaging device 30, and converts the signal output from depth imaging device 30 into a depth image and outputs the depth image.

Signal processing device 120 includes, for example, a processor (not illustrated in the drawings) and memory (not illustrated in the drawings), and is realized by the processor executing a program stored in the memory.

FIG. 2 is a circuit diagram illustrating a configuration of depth imaging device 30.

As illustrated in FIG. 2, depth imaging device 30 includes: pixel array 41; first driver 51; second driver 52; third driver 53; first delay adjustment circuit 61; second delay adjustment circuit 62; third delay adjustment circuit 63; control signal output circuit 70; first power supply terminal 71; second power supply terminal 72; third power supply terminal 73; fourth power supply terminal 74; first ground terminal 81; second ground terminal 82; third ground terminal 83; fourth ground terminal 84; power supply wiring 91; power supply wiring 92; ground wiring 96; and ground wiring 97.

Pixel array 41 includes a plurality of pixels 40 arranged in an array (matrix).

Pixel array 41 includes, for example, a plurality of pixels 40 arranged in a matrix of 720 rows and 1080 columns.

FIG. 3 is a schematic plan view illustrating a configuration of pixel 40.

As illustrated in FIG. 3, pixel 40 includes: photoelectric converter 1; charge accumulator 2 (for example, first charge accumulator 2a and second charge accumulator 2b); readout gate 6 (for example, first readout gate 6a (first gate electrode 6a) and second readout gate 6b (second gate electrode 6b)); output control gate 13; floating diffusion layer 14; reset gate 15; reset drain 16; readout circuit 17; exposure control gate 8 (third gate electrode 8) (for example, exposure control gate 8a and exposure control gate 8b); overflow drain 9 (for example, overflow drain 9a and overflow drain 9b); and charge holder 10.

Photoelectric converter 1 converts received light into charge.

Readout gate 6 reads out signal charge from photoelectric converter 1.

Charge accumulator 2 accumulates signal charge read out from readout gate 6. Charge accumulator 2 includes a transfer channel (CCD channel) 4 for transferring signal charge under the gate insulating film, and transfer electrode 5 (for example, any of transfer electrode 5a, transfer electrode 5b, transfer electrode 5c, transfer electrode 5d, or transfer electrode 5e) above the gate insulating film. Stated differently, as illustrated in FIG. 3, charge accumulator 2 includes a portion of transfer channel 4 and a portion of transfer electrode 5 that overlaps a portion of transfer channel 4 in a plan view of pixel array 41.

Here, the voltages applied to transfer electrode 5a, transfer electrode 5b, transfer electrode 5c, transfer electrode 5d, and transfer electrode 5e are denoted as VG1, VG2, VG3, VG4, and VG5, respectively.

First charge accumulator 2a and second charge accumulator 2b perform 5-phase driving. As one example, first charge accumulator 2a and second charge accumulator 2b are formed under transfer electrode 5 (here, under transfer electrode 5a and under transfer electrode 5c) to which VG1 and VG3, which become high voltage during exposure, are applied, and adjacent to first readout gate 6a and second readout gate 6b, respectively.

Overflow drain 9 discharges at least a portion of charge from photoelectric converter 1.

Exposure control gate 8 controls the abovementioned discharge to overflow drain 9.

Charge holder 10 receives transfer of signal charge accumulated in one of charge accumulators 2 (here, first charge accumulator 2a and second charge accumulator 2b) from that charge accumulator 2, holds the received signal charge, and transfers the held signal charge to one of charge accumulators 2 (here, first charge accumulator 2a and second charge accumulator 2b). As illustrated in FIG. 3, charge holder 10 includes charge holding gate 11 and transfer control gate 12 that performs transfer control of charge holder 10.

Floating diffusion layer 14 receives transfer of signal charge accumulated in one of charge accumulators 2 (here, first charge accumulator 2a and second charge accumulator 2b) from that charge accumulator 2, and holds the received signal charge.

Output control gate 13 performs transfer control to floating diffusion layer 14.

Readout circuit 17 converts signal charge held in floating diffusion layer 14 into current and reads the current out to the outside of pixel 40. For example, readout circuit 17 includes a source follower transistor including a gate connected to floating diffusion layer 14, and a selection transistor connected in series with the source follower transistor. For example, when readout circuit 17 is selected by the selection transistor, the signal charge held in floating diffusion layer 14 is read out to the outside of pixel 40 by that readout circuit 17.

FIG. 4 is a timing chart illustrating operation of pixel 40 during exposure.

First readout gate 6a is driven by a first drive signal (to be described later) output from first driver 51, second readout gate 6b is driven by a second drive signal (to be described later) output from second driver 52, and exposure control gate 8 (here, exposure control gates 8a and 8b) is driven by a third drive signal (to be described later) output from third driver 53.

Although not illustrated in FIG. 4, transfer electrodes 5a to 5e are driven by drive signals VG1 to VG5, respectively. During exposure of pixel 40, a high voltage is applied to VG1 and VG3, and a low voltage is applied to the others. Charge accumulation becomes possible under transfer electrode 5 applied with a high voltage. Stated differently, charge accumulator 2 (here, first charge accumulator 2a and second charge accumulator 2b) is formed by transfer electrode 5 (here, transfer electrode 5a and transfer electrode 5c) applied with a high voltage, and transfer channel 4 overlapping underneath transfer electrode 5.

In FIG. 4, period Tp is a period during which light source 110 emits pulsed irradiation light.

The reflected light from subject 130 of the irradiation light emitted by light source 110 reaches pixel 40 with delay Td corresponding to the distance to subject 130, and is converted into charge in photoelectric converter 1.

As an initial state, the third drive signal is high, that is, exposure control gate 8 is in a high state, and photoelectric converter 1 is in a reset state. The first drive signal and second drive signal are low, that is, first readout gate 6a and second readout gate 6b are in a low state, and first charge accumulator 2a and second charge accumulator 2b, which are maintained in a high state by transfer electrode 5a and transfer electrode 5c, are electrically isolated from photoelectric converter 1. In this state, charge generated in photoelectric converter 1 is discharged to overflow drain 9 via exposure control gate 8, and is not accumulated in photoelectric converter 1.

Next, third drive signal becomes low, that is, exposure control gate 8 enters a low state in synchronization with time t1 at which light source 110 emits irradiation light, and discharge of charge from photoelectric converter 1 to overflow drain 9 is stopped. This initiates the accumulation of charge generated in photoelectric converter 1.

At time t2, the first drive signal transitions from low to high, that is, first readout gate 6a transitions from a low state to a high state, and transfer of charge converted by photoelectric converter 1 resulting from incidence of reflected light to first charge accumulator 2a via first readout gate 6a begins. At time t3, the first drive signal transitions from high to low, that is, first readout gate 6a transitions from a high state to a low state, and transfer of charge converted by photoelectric converter 1 resulting from incidence of reflected light to first charge accumulator 2a via first readout gate 6a is stopped. As a result, charge (charge amount A0) resulting from the leading component, of the reflected light, that arrived between time t1 and time t3 is held in first charge accumulator 2a. Stated differently, charge amount A0 of the charge converted from the reflected light during the leading exposure period from time t1 to time t3 is held in first charge accumulator 2a.

At time t4, the second drive signal transitions from low to high, that is, second readout gate 6b transitions from a low state to a high state, and transfer of charge converted by photoelectric converter 1 resulting from incidence of reflected light to second charge accumulator 2b via second readout gate 6b begins. At time t5, the second drive signal transitions from high to low, that is, second readout gate 6b transitions from a high state to a low state, and transfer of charge converted by photoelectric converter 1 resulting from incidence of reflected light to second charge accumulator 2b via second readout gate 6b is stopped. As a result, charge (charge amount A1) resulting from the trailing component, of the reflected light, that arrived between time t3 and time t5 is held in second charge accumulator 2b. Stated differently, charge amount A1 of the charge converted from the reflected light during the trailing exposure period from time t3 to time t5 is held in second charge accumulator 2b.

Assuming the distance from depth imaging system 200 to subject 130 is d, d is calculated via the following equation using charge amount A0 of the charge resulting from the leading component of the reflected light, charge amount A1 of the charge resulting from the trailing component of the reflected light, and the speed of light c.

$$d = c \times Tp / 2 \times A1 / (A0 + A1)$$

Returning to FIG. 2, we will now continue the explanation of depth imaging device 30.

Control signal output circuit 70 outputs a first control signal that controls first readout gate 6a (first gate electrode 6a) of the plurality of pixels 40, a second control signal that controls second readout gate 6b (second gate electrode 6b) of the plurality of pixels 40, and a third control signal that controls exposure control gate 8 (third gate electrode 8) of the plurality of pixels 40. Control signal output circuit 70 further outputs a light source control signal that controls light source 110.

First delay adjustment circuit 61 receives input of the first control signal and the first drive signal, adjusts the delay time of the first control signal to make the phase difference between the first control signal and the first drive signal constant, and outputs a first delayed control signal with the adjusted delay time.

First delay adjustment circuit 61 is realized, for example, by a delay locked loop (DLL) circuit.

Second delay adjustment circuit 62 receives input of the second control signal and the second drive signal, adjusts the delay time of the second control signal to make the phase difference between the second control signal and the second drive signal constant, and outputs a second delayed control signal with the adjusted delay time.

Second delay adjustment circuit 62 is realized, for example, by a DLL circuit.

Third delay adjustment circuit 63 receives input of the third control signal and the third drive signal, adjusts the delay time of the third control signal to make the phase difference between the third control signal and the third drive signal constant, and outputs a third delayed control signal with the adjusted delay time.

Third delay adjustment circuit 63 is realized, for example, by a DLL circuit.

First driver 51 receives input of the first delayed control signal and outputs a first drive signal that drives first readout gates 6a (first gate electrodes 6a) of the plurality of pixels 40.

First driver 51 includes first driving element 51a and second driving element 51b arranged in positions opposing each other and sandwiching pixel array 41 in a first direction (the y-axis direction in FIG. 2) in a plan view of depth imaging device 30. Stated differently, first driver 51 includes first driving element 51a that is included in first driving element group 50a and second driving element 51b that is included in second driving element group 50b.

Here, as one non-limiting example, the final output stage circuit of first driving element 51a includes a plurality of inverters connected in parallel with each other, and the final output stage circuit of second driving element 51b includes a plurality of inverters connected in parallel with each other. Here, the length of the electrical paths from the output of control signal output circuit 70 to the input of each inverter in the final output stage of first driving element 51a, and the length of the electrical paths from the output of control signal output circuit 70 to the input of each inverter in the final output stage of second driving element 51b are equal. As a result, the output timing of the first drive signal from each inverter in the final output stage of first driving element 51a, and the output timing of the first drive signal from each inverter in the final output stage of second driving element 51b are aligned.

Second driver 52 receives input of the second delayed control signal and outputs a second drive signal that drives second readout gates 6b (second gate electrodes 6b) of the plurality of pixels 40.

Second driver 52 includes third driving element 52a and fourth driving element 52b arranged in positions opposing each other and sandwiching pixel array 41 in the first direction in a plan view of depth imaging device 30. Stated differently, second driver 52 includes third driving element 52a that is included in first driving element group 50a and fourth driving element 52b that is included in second driving element group 50b.

Here, as one non-limiting example, the final output stage circuit of third driving element 52a includes a plurality of inverters connected in parallel with each other, and the final output stage circuit of fourth driving element 52b includes a plurality of inverters connected in parallel with each other. Here, the length of the electrical paths from the output of control signal output circuit 70 to the input of each inverter in the final output stage of third driving element 52a, and the length of the electrical paths from the output of control signal output circuit 70 to the input of each inverter in the final output stage of fourth driving element 52b are equal. As a result, the output timing of the second drive signal from each inverter in the final output stage of third driving element 52a, and the output timing of the second drive signal from each inverter in the final output stage of fourth driving element 52b are aligned.

Third driver 53 receives input of the third delayed control signal and outputs a third drive signal that drives exposure control gates 8 (third gate electrodes 8) of the plurality of pixels 40.

Third driver 53 includes fifth driving element 53a and sixth driving element 53b arranged in positions opposing each other and sandwiching pixel array 41 in the first direction in a plan view of depth imaging device 30. Stated differently, third driver 53 includes fifth driving element 53a that is included in first driving element group 50a and sixth driving element 53b that is included in second driving element group 50b.

Here, as one non-limiting example, the final output stage circuit of fifth driving element 53a includes a plurality of inverters connected in parallel with each other, and the final output stage circuit of sixth driving element 53b includes a plurality of inverters connected in parallel with each other. Here, the length of the electrical paths from the output of control signal output circuit 70 to the input of each inverter in the final output stage of fifth driving element 53a, and the length of the electrical paths from the output of control signal output circuit 70 to the input of each inverter in the final output stage of sixth driving element 53b are equal. As a result, the output timing of the third drive signal from each inverter in the final output stage of fifth driving element 53a, and the output timing of the third drive signal from each inverter in the final output stage of sixth driving element 53b are aligned.

As illustrated in FIG. 2, first driving element group 50a includes first driving element 51a, third driving element 52a, and fifth driving element 53a, and second driving element group 50b includes second driving element 51b, fourth driving element 52b, and sixth driving element 53b.

FIG. 5 is a schematic diagram illustrating a schematic configuration of first driving element group 50a and second driving element group 50b.

In FIG. 5, one of the inverters in the final stage of first driving element 51a is illustrated as a representative of circuit 51aa constituting first driving element 51a, one of the inverters in the final stage of third driving element 52a is illustrated as a representative of circuit 52aa constituting third driving element 52a, one of the inverters in the final stage of fifth driving element 53a is illustrated as a representative of circuit 53aa constituting fifth driving element 53a, one of the inverters in the final stage of second driving element 51b is illustrated as a representative of circuit 51ba constituting second driving element 51b, one of the inverters in the final stage of fourth driving element 52b is illustrated as a representative of circuit 52ba constituting fourth driving element 52b, and one of the inverters in the final stage of sixth driving element 53b is illustrated as a representative of circuit 53ba constituting sixth driving element 53b.

As illustrated in FIG. 5, in first driving element group 50a, a power supply potential is supplied from common power supply wiring 91 and a ground potential is supplied from common ground wiring 96 to circuit 51aa constituting first driving element 51a, circuit 52aa constituting third driving element 52a, and circuit 53aa constituting fifth driving element 53a.

In second driving element group 50b, a power supply potential is supplied from common power supply wiring 92 and a ground potential is supplied from common ground wiring 97 to circuit 51ba constituting second driving element 51b, circuit 52ba constituting fourth driving element 52b, and circuit 53ba constituting sixth driving element 53b.

Stated differently, first power supply wiring that supplies the power supply potential to first driver 51, second power supply wiring that supplies the power supply potential to second driver 52, and third power supply wiring that supplies the power supply potential to third driver 53 have a common portion, and first ground wiring that supplies the ground potential to first driver 51, second ground wiring that supplies the ground potential to second driver 52, and third ground wiring that supplies the ground potential to third driver 53 have a common portion.

As illustrated in FIG. 5, first power supply terminal 71 and second power supply terminal 72 are connected to power supply wiring 91, first ground terminal 81 and second ground terminal 82 are connected to ground wiring 96, third power supply terminal 73 and fourth power supply terminal 74 are connected to power supply wiring 92, and third ground terminal 83 and fourth ground terminal 84 are connected to ground wiring 97.

Here, first power supply terminal 71 and second power supply terminal 72 are arranged in positions opposing each other and sandwiching first driving element group 50a (first driving element 51a) in a second direction (the x-axis direction in FIG. 5) orthogonal to the first direction in a plan view of depth imaging device 30, third power supply terminal 73 and fourth power supply terminal 74 are arranged in positions opposing each other and sandwiching second driving element group 50b (second driving element 51b) in the second direction in a plan view of depth imaging device 30, first ground terminal 81 and second ground terminal 82 are arranged in positions opposing each other and sandwiching first driving element group 50a (first driving element 51a) in the second direction in a plan view of depth imaging device 30, and third ground terminal 83 and fourth ground terminal 84 are arranged in positions opposing each other and sandwiching second driving element group 50b (second driving element 51b) in the second direction in a plan view of depth imaging device 30. Here, the length of the electrical path from first power supply terminal 71 to first driving element group 50a in power supply wiring 91, the length of the electrical path from second power supply terminal 72 to first driving element group 50a in power supply wiring 91, the length of the electrical path from third power supply terminal 73 to second driving element group 50b in power supply wiring 92, the length of the electrical path from fourth power supply terminal 74 to second driving element group 50b in power supply wiring 92, the length of the electrical path from first ground terminal 81 to first driving element group 50a in ground wiring 96, the length of the electrical path from second ground terminal 82 to first driving element group 50a in ground wiring 96, the length of the electrical path from third ground terminal 83 to second driving element group 50b in ground wiring 97, and the length of the electrical path from fourth ground terminal 84 to second driving element group 50b in ground wiring 97 are equal.

FIG. 6 is a schematic plan view illustrating a configuration of package 100.

As illustrated in FIG. 6, package 100 includes: depth imaging device 30; first internal power supply terminal 101; second internal power supply terminal 102; third internal power supply terminal 103; fourth internal power supply terminal 104; first internal ground terminal 111; second internal ground terminal 112; third internal ground terminal 113; fourth internal ground terminal 114; first external power supply terminal 201; second external power supply terminal 202; first external ground terminal 211; and second external ground terminal 212.

First internal power supply terminal 101 is connected to first power supply terminal 71. Second internal power supply terminal 102 is connected to second power supply terminal 72. Third internal power supply terminal 103 is connected to third power supply terminal 73. Fourth internal power supply terminal 104 is connected to fourth power supply terminal 74.

First internal ground terminal 111 is connected to first ground terminal 81. Second internal ground terminal 112 is connected to second ground terminal 82. Third internal ground terminal 113 is connected to third ground terminal 83. Fourth internal ground terminal 114 is connected to fourth ground terminal 84.

First external power supply terminal 201 is connected to first internal power supply terminal 101 and third internal power supply terminal 103. Second external power supply terminal 202 is connected to second internal power supply terminal 102 and fourth internal power supply terminal 104.

First external ground terminal 211 is connected to first internal ground terminal 111 and third internal ground terminal 113. Second external ground terminal 212 is connected to second internal ground terminal 112 and fourth internal ground terminal 114.

Here, the difference in length between each of the following four electrical paths is less than or equal to 3 mm: (1) the electrical path from first external power supply terminal 201 to first internal power supply terminal 101; (2) the electrical path from first external power supply terminal 201 to third internal power supply terminal 103; (3) the electrical path from second external power supply terminal 202 to second internal power supply terminal 102; and (4) the electrical path from second external power supply terminal 202 to fourth internal power supply terminal 104. At this time, the difference in inductance between each of these four electrical paths is less than or equal to 2 nH.

[Observations]

FIG. 7 is a circuit diagram illustrating a configuration of depth imaging device 300 of a type that does not include first delay adjustment circuit 61, second delay adjustment circuit 62, and third delay adjustment circuit 63.

As illustrated in FIG. 7, depth imaging device 300 is configured by removing first delay adjustment circuit 61, second delay adjustment circuit 62, and third delay adjustment circuit 63 from depth imaging device 30 illustrated in FIG. 2. In depth imaging device 300, the first control signal, second control signal, and third control signal output from control signal output circuit 70 are input directly to first driver 51, second driver 52, and third driver 53, respectively.

Similarly to the explanation of depth imaging device 30 given earlier, in depth imaging device 300 as well, the power supply potential is supplied to first driver 51, second driver 52, and third driver 53 from common power supply wiring 91 and common power supply wiring 92, and the ground potential is supplied from common ground wiring 96 and common ground wiring 97.

Therefore, when first driver 51 outputs the first drive signal, that is, when first driver 51 operates, a period occurs during which the power supply potential and ground potential supplied to second driver 52 and third driver 53 fluctuate. Accordingly, if second driver 52 and/or third driver 53 operate during this period, the delay time of second driver 52 and/or third driver 53 fluctuates.

Similarly, when second driver 52 outputs the second drive signal, that is, when second driver 52 operates, a period occurs during which the power supply potential and ground potential supplied to third driver 53 and first driver 51 fluctuate. Accordingly, if third driver 53 and/or first driver 51 operate during this period, the delay time of third driver 53 and/or first driver 51 fluctuates.

Furthermore, similarly, when third driver 53 outputs the third drive signal, that is, when third driver 53 operates, a period occurs during which the power supply potential and ground potential supplied to first driver 51 and second driver 52 fluctuate. Accordingly, if first driver 51 and/or second driver 52 operate during this period, the delay time of first driver 51 and/or second driver 52 fluctuates.

Therefore, depending on the operation timing of first driver 51, second driver 52, and third driver 53, the operation timing of first readout gate 6a (first gate electrode 6a), the operation timing of second readout gate 6b (second gate electrode 6b), and the operation timing of exposure control gate 8 (third gate electrode 8) in each pixel 40 may fluctuate.

If the operation timing of first readout gate 6a (first gate electrode 6a), the operation timing of second readout gate 6b (second gate electrode 6b), and the operation timing of exposure control gate 8 (third gate electrode 8) in each pixel 40 fluctuate, depth measurement accuracy decreases.

FIG. 8 is a waveform diagram in a simulation of the operation of first driver 51, second driver 52, and third driver 53 during exposure of pixel 40.

In FIG. 8, the upper waveforms show the waveforms of the first control signal, the second control signal, and the third control signal input to first driver 51, second driver 52, and third driver 53, respectively. The lower waveforms show the waveforms of the first drive signal, the second drive signal, and the third drive signal output from first driver 51, second driver 52, and third driver 53, respectively.

As illustrated in FIG. 8, when third driver 53 drives the third drive signal from high to low, charge accumulated in the load capacitance of the third drive signal (for example, the gate capacitance of exposure control gate 8, the wiring capacitance of the wiring of the third drive signal, etc.) flows into ground wiring 96 and ground wiring 97, causing the electric potential of ground wiring 96 and ground wiring 97 to rise.

As mentioned above, ground wiring 96 and ground wiring 97 are ground wiring common to first driver 51. Therefore, as illustrated in FIG. 8, when first driver 51 drives the first drive signal from low to high during the period when the electric potential of ground wiring 96 and ground wiring 97 is elevated, the operation timing of the first drive signal fluctuates. In such cases, this simulation shows that the operation timing of the first drive signal fluctuates in a direction of being delayed. Stated differently, this simulation shows that the delay time of first driver 51 fluctuates in a direction of being delayed.

Therefore, as illustrated in FIG. 8, in each pixel 40, the leading exposure period defined by the third drive signal and the first drive signal fluctuates to become longer than the leading exposure setting period set by the third control signal and the first control signal.

The same applies to the relationship between the first drive signal and the second drive signal, as well as the relationship between the second drive signal and the third drive signal.

For example, if an exposure period such as the leading exposure period or the trailing exposure period fluctuates by 20 ps, a depth measurement error of 3 mm occurs.

In contrast, with depth imaging device 30 configured as described above, by including first delay adjustment circuit 61 and second delay adjustment circuit 62, the phase difference between the first control signal and the first drive signal, and the phase difference between the second control signal and the second drive signal are maintained constant. Therefore, even if the power supply potential or ground potential supplied to first driver 51 fluctuates and the delay time of first driver 51 fluctuates, or even if the power supply potential or ground potential supplied to second driver 52 fluctuates and the delay time of second driver 52 fluctuates, the operation timing of first readout gate 6a (first gate electrode 6a) and the operation timing of second readout gate 6b (second gate electrode 6b) in each pixel 40 do not fluctuate.

Accordingly, accurate depth measurement can be performed with depth imaging device 30 configured as described above.

Furthermore, with depth imaging device 30 configured as described above, by including third delay adjustment circuit 63, the phase difference between the third control signal and the third drive signal is maintained constant. Therefore, even if the power supply potential or ground potential supplied to third driver 53 fluctuates and the delay time of third driver 53 changes, the operation timing of exposure control gate 8 (third gate electrode 8) in each pixel does not fluctuate.

Accordingly, even more accurate depth measurement can be performed with depth imaging device 30 configured as described above.

The above-described effect, namely, the advantageous effect of being able to accurately measure depth, becomes greater as the exposure period, that is, the period for accumulating charge converted by photoelectric converter 1, becomes shorter. In particular, the above-described advantageous effect becomes significant when the exposure period becomes 10 ns or less, and becomes even more significant when the exposure period becomes 7 ns or less.

Therefore, in order to significantly achieve the above-described advantageous effect, it is desirable that control signal output circuit 70 has a configuration that outputs a first control signal including a pulse with a pulse width of 10 ns or less and a second control signal including a pulse with a pulse width of 10 ns or less.

FIG. 9 is a graph illustrating the relationship between the leading exposure setting period in the third control signal and the first control signal, and the leading exposure period in the third drive signal and the first drive signal, in depth imaging device 300 of a type that does not include first delay adjustment circuit 61, second delay adjustment circuit 62, and third delay adjustment circuit 63.

In FIG. 9, the leading exposure setting period [ns] is represented on the horizontal axis, and the leading exposure period [ns] is represented on the vertical axis.

FIG. 10 is a graph illustrating the relationship between the leading exposure setting period in the third control signal and the first control signal, and the leading exposure period in the third drive signal and the first drive signal, in depth imaging device 30 of a type that includes first delay adjustment circuit 61, second delay adjustment circuit 62, and third delay adjustment circuit 63.

In FIG. 10, the leading exposure setting period [ns] is represented on the horizontal axis, and the leading exposure period [ns] is represented on the vertical axis.

As illustrated in FIG. 9, in depth imaging device 300 of a type that does not include first delay adjustment circuit 61, second delay adjustment circuit 62, and third delay adjustment circuit 63, the shorter the leading exposure setting period becomes, the greater the discrepancy between the leading exposure period and the leading exposure setting period becomes. In contrast, as illustrated in FIG. 10, in depth imaging device 30 of a type that does include first delay adjustment circuit 61, second delay adjustment circuit 62, and third delay adjustment circuit 63, even when the leading exposure setting period becomes shorter, no significant discrepancy occurs between the leading exposure period and the leading exposure setting period.

Thus, with depth imaging device 30 configured as described above, accurate depth measurement can be performed even if control signal output circuit 70 has a configuration that outputs a first control signal including a pulse with a pulse width of 10 ns or less and a second control signal including a pulse with a pulse width of 10 ns or less.

FIG. 11 is a graph illustrating a distribution of ideal delay times of drive signals with respect to positions in the column direction (the direction in which the first drive signal, the second drive signal, and the third drive signal (hereinafter, when there is no need to explicitly distinguish between these three, they may be simply referred to as "drive signals") propagate) in pixel array 41.

In FIG. 11, the position in the column direction is represented on the horizontal axis, and the delay time is represented on the vertical axis.

As illustrated in FIG. 11, the distribution of delay times with respect to positions in the column direction forms a mountain-like shape where the delay times in the central portion farther from first driver 51, second driver 52, and the third driver (hereinafter, when there is no need to explicitly distinguish between these three, they may be simply referred to as "drivers") are greater than those in the upper and lower portions closer to the drivers.

Since this mountain-like shape is determined in a simplistic manner using the resistance and parasitic capacitance of the wiring in the column direction within pixel array 41, errors in depth measurement accuracy due to differences in delay times can be corrected through signal processing or other means.

As illustrated in FIG. 11, when the temperature fluctuates, the absolute value of the delay time fluctuates.

Errors in depth measurement accuracy due to fluctuations in delay time accompanying this fluctuation in temperature can also be corrected through signal processing or other means based on the temperature detected by a temperature sensor or the like.

However, through various simulations and other means, the inventors noticed that if the electrical characteristics of the electrical path, in the package packaging depth imaging device 30, that supplies the power supply potential from the power supply potential supply point to the driver, and the electrical path, in the package, that supplies the ground potential from the ground supply point to the driver, are not maintained within a certain range of symmetry, the above-mentioned mountain-like shape becomes distorted. Stated differently, fluctuations in operation timing between pixels 40 at different physical positions occur that are difficult to correct through signal processing or other means.

FIG. 12 is a graph illustrating simulation results of the distribution of delay times of drive signals with respect to positions in the column direction, in a case where simulation is performed with the difference in length between each of the following four electrical paths set to not fall within 3 mm or less, that is, to not fall within 2 nH or less (also referred to as "simulation under the first simulation condition"): (1) the electrical path from first external power supply terminal 201 to first internal power supply terminal 101; (2) the electrical path from first external power supply terminal 201 to third internal power supply terminal 103; (3) the electrical path from second external power supply terminal 202 to second internal power supply terminal 102; and (4) the electrical path from second external power supply terminal 202 to fourth internal power supply terminal 104.

In FIG. 12, the position in the column direction is represented on the horizontal axis, and the delay time is represented on the vertical axis.

As illustrated in FIG. 12, when the difference in length between each of the above-mentioned four electrical paths does not fall within 3 mm or less, the distortion of the above-mentioned mountain-like shape becomes more pronounced as the exposure period becomes shorter.

FIG. 13 is a graph illustrating the relationship between (1) a first exposure period and (2) the delay difference, which is the difference between the value of the delay time of the first drive signal in the central portion and the value of the delay time of the first drive signal the upper and lower portions in the vertical direction of pixel array 41, in a case where simulation is performed under the first simulation condition.

In FIG. 13, the first exposure period [ns] is represented on the horizontal axis, and the delay difference [ps] is represented on the vertical axis.

FIG. 14 is a graph illustrating the relationship between (1) a first exposure period and (2) the delay difference, which is the difference between the value of the delay time of the first drive signal in the central portion and the value of the delay time of the first drive signal the upper and lower portions in the vertical direction of pixel array 41, in a case where simulation is performed with the above-mentioned four electrical paths set to reproduce the electrical paths in actual package 100, that is, in a case where simulation is performed with the difference in length between each of the above-mentioned four electrical paths set to be less than or equal to 3 mm (also referred to as "simulation under the second simulation condition").

In FIG. 14, the first exposure period [ns] is represented on the horizontal axis, and the delay difference [ps] is represented on the vertical axis.

From FIG. 13 and FIG. 14, it can be seen that by setting the difference in length between each of the above-mentioned four electrical paths to be less than or equal to 3 mm, that is, by setting the difference in inductance between each of these four electrical paths to be less than or equal to 2 nH, the distortion of the above-mentioned mountain-like shape is inhibited.

Thus, with package 100 configured as described above, even when the timing at which the drive signal reaches pixels 40 fluctuates, the difference in the amount of fluctuation in the operation timing of the drive signal between pixels 40 at different physical positions can be inhibited (maintained within a certain range).

Accordingly, accurate depth measurement can be performed with package 100 configured as described above.

Depth imaging device 30 may be, for example, configured as a single semiconductor chip, or may be configured as a plurality of semiconductor chips stacked on each other.

FIG. 15A is a perspective view of depth imaging device 30 in an example where depth imaging device 30 is configured as a single semiconductor chip 31.

FIG. 15B is an exploded perspective view of depth imaging device 30 in an example where depth imaging device 30 is configured as first semiconductor chip 32 and second semiconductor chip 33 stacked on each other.

FIG. 15C is a perspective view of depth imaging device 30 in an example where depth imaging device 30 is configured as first semiconductor chip 32 and second semiconductor chip 33 stacked on each other.

As illustrated in FIG. 15A, depth imaging device 30 may be configured as a single semiconductor chip 31 on which pixel array 41, first driving element group 50a, and second driving element group 50b are formed, that is, on which pixel array 41, first driver 51, second driver 52, and third driver 53 are formed. Alternatively, as illustrated in FIG. 15B and FIG. 15C, depth imaging device 30 may be configured as first semiconductor chip 32 on which pixel array 41 is formed and second semiconductor chip 32 on which first driving element group 50a and second driving element group 50b are formed, that is, on which first driver 51, second driver 52, and third driver 53 are formed, stacked on each other.

[Variation 1]

Hereinafter, a package according to Variation 1 configured by modifying a part of package 100 according to Embodiment 1 will be described.

Hereinafter, regarding the package according to Variation 1, the same reference numerals are assigned and detailed explanations are omitted for elements that are the same as those in package 100 as they have already been described, and the explanation will focus on the differences from package 100.

[Configuration]

FIG. 16 is a schematic plan view illustrating a configuration of package 100a according to Variation 1.

As illustrated in FIG. 16, package 100a is configured by modifying package 100 according to Embodiment 1 as follows: depth imaging device 30 is changed to depth imaging device 30a; first internal power supply terminal 101, second internal power supply terminal 102, third internal power supply terminal 103, and fourth internal power supply terminal 104 are changed to first internal power supply terminal 101a, second internal power supply terminal 102a, third internal power supply terminal 103a, and fourth internal power supply terminal 104a, respectively; first internal ground terminal 111, second internal ground terminal 112, third internal ground terminal 113, and fourth internal ground terminal 114 are changed to first internal ground terminal 111a, second internal ground terminal 112a, third internal ground terminal 113a, and fourth internal ground terminal 114a, respectively; first external power supply terminal 201 and second external power supply terminal 202 are changed to first external power supply terminal 201a and second external power supply terminal 202a, respectively; and first external ground terminal 211 and second external ground terminal 212 are changed to first external ground terminal 211a and second external ground terminal 212a, respectively.

Depth imaging device 30a is configured by modifying depth imaging device 30 according to Embodiment 1 as follows: first ground terminal 81 is changed to first ground terminal 81a with its placement position changed, second ground terminal 82 is changed to second ground terminal 82a with its placement position changed, third ground terminal 83 is changed to third ground terminal 83a with its placement position changed, and fourth ground terminal 84 is changed to fourth ground terminal 84a with its placement position changed.

First internal power supply terminal 101a is connected to first power supply terminal 71. Second internal power supply terminal 102a is connected to second power supply terminal 72. Third internal power supply terminal 103a is connected to third power supply terminal 73. Fourth internal power supply terminal 104a is connected to fourth power supply terminal 74.

First internal ground terminal 111a is connected to first ground terminal 81a. Second internal ground terminal 112a is connected to second ground terminal 82a. Third internal ground terminal 113a is connected to third ground terminal 83a. Fourth internal ground terminal 114a is connected to fourth ground terminal 84a.

First external power supply terminal 201a is connected to first internal power supply terminal 101a and second internal power supply terminal 102a. Second external power supply terminal 202a is connected to third internal power supply terminal 103a and fourth internal power supply terminal 104a.

First external ground terminal 211a is connected to first internal ground terminal 111a and second internal ground terminal 112a. Second external ground terminal 212a is connected to third internal ground terminal 113a and fourth internal ground terminal 114a.

Here, the difference in length between each of the following four electrical paths is less than or equal to 3 mm: (1) the electrical path from first external power supply terminal 201a to first internal power supply terminal 101a; (2) the electrical path from first external power supply terminal 201a to second internal power supply terminal 102a; (3) the electrical path from second external power supply terminal 202a to third internal power supply terminal 103a; and (4) the electrical path from second external power supply terminal 202a to fourth internal power supply terminal 104a. At this time, the difference in inductance between each of these four electrical paths is less than or equal to 2 nH.

[Observations]

As described above, in package 100a configured as described above, the difference in length between each of the above-mentioned four electrical paths is less than or equal to 3 mm, and the difference in inductance between each of these four electrical paths is less than or equal to 2 nH.

Accordingly, similar to package 100 according to Embodiment 1, accurate depth measurement can be performed with package 100a configured as described above.

[Variation 2]

Hereinafter, a package according to Variation 2 configured by modifying a part of package 100 according to Embodiment 1 will be described.

Hereinafter, regarding the package according to Variation 2, the same reference numerals are assigned and detailed explanations are omitted for elements that are the same as those in package 100 as they have already been described, and the explanation will focus on the differences from package 100.

[Configuration]

FIG. 17 is a schematic plan view illustrating a configuration of package 100b according to Variation 2.

As illustrated in FIG. 17, package 100b is configured by modifying package 100 according to Embodiment 1 as follows: first external power supply terminal 201 and second external power supply terminal 202 are changed to first external power supply terminal 201b, second external power supply terminal 202b, third external power supply terminal 203b, and fourth external power supply terminal 204b; and first external ground terminal 211 and second external ground terminal 212 are changed to first external ground terminal 211b, second external ground terminal 212b, third external ground terminal 213b, and fourth external ground terminal 214b.

First external power supply terminal 201b is connected to first internal power supply terminal 101. Second external power supply terminal 202b is connected to second internal power supply terminal 102. Third external power supply terminal 203b is connected to third internal power supply terminal 103. Fourth external power supply terminal 204b is connected to fourth internal power supply terminal 104.

First external ground terminal 211b is connected to first internal ground terminal 111. Second external ground terminal 212a is connected to second internal ground terminal 112. Third external ground terminal 213b is connected to third internal ground terminal 113. Fourth external ground terminal 214b is connected to fourth internal ground terminal 114.

Here, the difference in length between each of the following four electrical paths is less than or equal to 3 mm: (1) the electrical path from first external power supply terminal 201b to first internal power supply terminal 101; (2) the electrical path from second external power supply terminal 202b to second internal power supply terminal 102; (3) the electrical path from third external power supply terminal 203b to third internal power supply terminal 103; and (4) the electrical path from fourth external power supply terminal 204b to fourth internal power supply terminal 104. At this time, the difference in inductance between each of these four electrical paths is less than or equal to 2 nH.

[Observations]

As described above, in package 100b configured as described above, the difference in length between each of the above-mentioned four electrical paths is less than or equal to 3 mm, and the difference in inductance between each of these four electrical paths is less than or equal to 2 nH.

Accordingly, similar to package 100 according to Embodiment 1, accurate depth measurement can be performed with package 100b configured as described above.

[Variation 3]

Hereinafter, a package according to Variation 3 configured by modifying a part of package 100 according to Embodiment 1 will be described.

Hereinafter, regarding the package according to Variation 3, the same reference numerals are assigned and detailed explanations are omitted for elements that are the same as those in package 100 as they have already been described, and the explanation will focus on the differences from package 100.

[Configuration]

FIG. 18 is a schematic plan view illustrating a configuration of package 100c according to Variation 3.

As illustrated in FIG. 18, package 100c is configured by modifying package 100 according to Embodiment 1 such that depth imaging device 30 is changed to depth imaging device 300.

[Observations]

Similar to package 100 according to Embodiment 1, in package 100c configured as described above, the difference in length between each of the following four electrical paths is less than or equal to 3 mm: (1) the electrical path from first external power supply terminal 201 to first internal power supply terminal 101; (2) the electrical path from first external power supply terminal 201 to third internal power supply terminal 103; (3) the electrical path from second external power supply terminal 202 to second internal power supply terminal 102; and (4) the electrical path from second external power supply terminal 202 to fourth internal power supply terminal 104. At this time, the difference in inductance between each of these four electrical paths is less than or equal to 2 nH.

Accordingly, similar to package 100 according to Embodiment 1, accurate depth measurement can be performed with package 100c configured as described above.

[Variation 4]

Hereinafter, a package according to Variation 4 configured by modifying a part of package 100a according to Variation 1 will be described.

Hereinafter, regarding the package according to Variation 4, the same reference numerals are assigned and detailed explanations are omitted for elements that are the same as those in package 100a as they have already been described, and the explanation will focus on the differences from package 100a.

[Configuration]

FIG. 19 is a schematic plan view illustrating a configuration of package 100d according to Variation 4.

As illustrated in FIG. 19, package 100d is configured by modifying package 100a according to Variation 1 such that depth imaging device 30a is changed to depth imaging device 300a.

Depth imaging device 300a is configured by modifying depth imaging device 300 as follows: first ground terminal 81 is changed to first ground terminal 81a with its placement position changed to the same position as in depth imaging device 30a, second ground terminal 82 is changed to second ground terminal 82a with its placement position changed to the same position as in depth imaging device 30a, third ground terminal 83 is changed to third ground terminal 83a with its placement position changed to the same position as in depth imaging device 30a, and fourth ground terminal 84 is changed to fourth ground terminal 84a with its placement position changed to the same position as in depth imaging device 30a.

[Observations]

Similar to package 100a according to Variation 1, in package 100d configured as described above, the difference in length between each of the following four electrical paths is less than or equal to 3 mm: (1) the electrical path from first external power supply terminal 201a to first internal power supply terminal 101a; (2) the electrical path from first external power supply terminal 201a to second internal power supply terminal 102a; (3) the electrical path from second external power supply terminal 202a to third internal power supply terminal 103a; and (4) the electrical path from second external power supply terminal 202a to fourth internal power supply terminal 104a. At this time, the difference in inductance between each of these four electrical paths is less than or equal to 2 nH.

Accordingly, similar to package 100a according to Variation 1, accurate depth measurement can be performed with package 100d configured as described above.

[Variation 5]

Hereinafter, a package according to Variation 5 configured by modifying a part of package 100b according to Variation 2 will be described.

Hereinafter, regarding the package according to Variation 5, the same reference numerals are assigned and detailed explanations are omitted for elements that are the same as those in package 100b as they have already been described, and the explanation will focus on the differences from package 100b.

[Configuration]

FIG. 20 is a schematic plan view illustrating a configuration of package 100e according to Variation 5.

As illustrated in FIG. 20, package 100e is configured by modifying package 100b according to Variation 2 such that depth imaging device 30 is changed to depth imaging device 300.

[Observations]

Similar to package 100b according to Variation 2, in package 100e configured as described above, the difference in length between each of the following four electrical paths is less than or equal to 3 mm: (1) the electrical path from first external power supply terminal 201b to first internal power supply terminal 101; (2) the electrical path from second external power supply terminal 202b to second internal power supply terminal 102; (3) the electrical path from third external power supply terminal 203b to third internal power supply terminal 103; and (4) the electrical path from fourth external power supply terminal 204b to fourth internal power supply terminal 104. At this time, the difference in inductance between each of these four electrical paths is less than or equal to 2 nH.

Accordingly, similar to package 100b according to Variation 2, accurate depth measurement can be performed with package 100e configured as described above.

(Embodiment 2)

[Configuration]

FIG. 21 is a functional block diagram illustrating a schematic configuration of depth imaging system 200a according to Embodiment 2.

As illustrated in FIG. 21, depth imaging system 200a is configured by modifying depth imaging system 200 according to Embodiment 1 such that package 100 is changed to module 1000.

FIG. 22 is a schematic plan view illustrating a configuration of module 1000.

As illustrated in FIG. 22, module 1000 includes mounting substrate 500 and depth imaging device 30.

Mounting substrate 500 is provided with depth imaging device 30 mounted thereon, and includes: first internal power supply terminal 501; second internal power supply terminal 502; third internal power supply terminal 503; fourth internal power supply terminal 504; first internal ground terminal 511; second internal ground terminal 512; third internal ground terminal 513; fourth internal ground terminal 514; first bypass capacitor 601; and second bypass capacitor 602.

First internal power supply terminal 501 is connected to first power supply terminal 71. Second internal power supply terminal 502 is connected to second power supply terminal 72. Third internal power supply terminal 503 is connected to third power supply terminal 73. Fourth internal power supply terminal 504 is connected to fourth power supply terminal 74.

First internal ground terminal 511 is connected to first ground terminal 81. Second internal ground terminal 512 is connected to second ground terminal 82. Third internal ground terminal 513 is connected to third ground terminal 83. Fourth internal ground terminal 514 is connected to fourth ground terminal 84.

One terminal of first bypass capacitor 601 is connected to first internal power supply terminal 501 and third internal power supply terminal 503, and the other terminal is connected to first internal ground terminal 511 and third internal ground terminal 513.

One terminal of second bypass capacitor 602 is connected to second internal power supply terminal 502 and fourth internal power supply terminal 504, and the other terminal is connected to second internal ground terminal 512 and fourth internal ground terminal 514.

Here, the difference in length between each of the following four electrical paths is less than or equal to 3 mm: (1) the electrical path from first bypass capacitor 601 to first internal power supply terminal 501; (2) the electrical path from first bypass capacitor 601 to third internal power supply terminal 503; (3) the electrical path from second bypass capacitor 602 to second internal power supply terminal 502; and (4) the electrical path from second bypass capacitor 602 to fourth internal power supply terminal 504. At this time, the difference in inductance between each of these four electrical paths is less than or equal to 2 nH.

[Observations]

As described above, in module 1000 configured as described above, the difference in length between each of the above-mentioned four electrical paths is less than or equal to 3 mm, and the difference in inductance between each of these four electrical paths is less than or equal to 2 nH.

Accordingly, similar to package 100 according to Embodiment 1, accurate depth measurement can be performed with module 1000 configured as described above.

[Variation 6]

Hereinafter, a module according to Variation 6 configured by modifying a part of module 1000 according to Embodiment 2 will be described.

Hereinafter, regarding the module according to Variation 6, the same reference numerals are assigned and detailed explanations are omitted for elements that are the same as those in module 1000 as they have already been described, and the explanation will focus on the differences from module 1000.

[Configuration]

FIG. 23 is a schematic plan view illustrating a configuration of module 1000a according to Variation 6.

As illustrated in FIG. 23, module 1000a is configured by modifying module 1000 according to Embodiment 2 such that depth imaging device 30 is changed to depth imaging device 30a and mounting substrate 500 is changed to mounting substrate 500a.

Mounting substrate 500a is configured by modifying mounting substrate 500 as follows: first internal power supply terminal 501, second internal power supply terminal 502, third internal power supply terminal 503, and fourth internal power supply terminal 504 are changed to first internal power supply terminal 501a, second internal power supply terminal 502a, third internal power supply terminal 503a, and fourth internal power supply terminal 504a, respectively; first internal ground terminal 511, second internal ground terminal 512, third internal ground terminal 513, and fourth internal ground terminal 514a are changed to first internal ground terminal 511a, second internal ground terminal 512a, third internal ground terminal 513a, and fourth internal ground terminal 514a, respectively; and first bypass capacitor 601 and second bypass capacitor 602 are changed to first bypass capacitor 601a and second bypass capacitor 602a, respectively.

First internal power supply terminal 501a is connected to first power supply terminal 71. Second internal power supply terminal 502a is connected to second power supply terminal 72. Third internal power supply terminal 503a is connected to third power supply terminal 73. Fourth internal power supply terminal 504a is connected to fourth power supply terminal 74.

First internal ground terminal 511a is connected to first ground terminal 81a. Second internal ground terminal 512a is connected to second ground terminal 82a. Third internal ground terminal 513a is connected to third ground terminal 83a. Fourth internal ground terminal 514a is connected to fourth ground terminal 84a.

One terminal of first bypass capacitor 601a is connected to first internal power supply terminal 501a and second internal power supply terminal 502a, and the other terminal is connected to first internal ground terminal 511a and second internal ground terminal 512a.

One terminal of second bypass capacitor 602a is connected to third internal power supply terminal 503a and fourth internal power supply terminal 504a, and the other terminal is connected to third internal ground terminal 513a and fourth internal ground terminal 514a.

Here, the difference in length between each of the following four electrical paths is less than or equal to 3 mm: (1) the electrical path from first bypass capacitor 601a to first internal power supply terminal 501a; (2) the electrical path from first bypass capacitor 601a to second internal power supply terminal 502a; (3) the electrical path from second bypass capacitor 602a to third internal power supply terminal 503a; and (4) the electrical path from second bypass capacitor 602a to fourth internal power supply terminal 504a. At this time, the difference in inductance between each of these four electrical paths is less than or equal to 2 nH.

[Observations]

As described above, in module 1000a configured as described above, the difference in length between each of the above-mentioned four electrical paths is less than or equal to 3 mm, and the difference in inductance between each of these four electrical paths is less than or equal to 2 nH.

Accordingly, similar to module 1000 according to Embodiment 2, accurate depth measurement can be performed with module 1000a configured as described above.

[Variation 7]

Hereinafter, a module according to Variation 7 configured by modifying a part of module 1000 according to Embodiment 2 will be described.

Hereinafter, regarding the module according to Variation 7, the same reference numerals are assigned and detailed explanations are omitted for elements that are the same as those in module 1000 as they have already been described, and the explanation will focus on the differences from module 1000.

[Configuration]

FIG. 24 is a schematic plan view illustrating a configuration of module 1000b according to Variation 7.

As illustrated in FIG. 24, module 1000b is configured by modifying module 1000 according to Embodiment 2 such that first bypass capacitor 601 and second bypass capacitor 602 are changed to first bypass capacitor 601b, second bypass capacitor 602b, third bypass capacitor 603b, and fourth bypass capacitor 604b.

One terminal of first bypass capacitor 601b is connected to first internal power supply terminal 501, and the other terminal is connected to first internal ground terminal 511.

One terminal of second bypass capacitor 602b is connected to second internal power supply terminal 502, and the other terminal is connected to second internal ground terminal 512.

One terminal of third bypass capacitor 603b is connected to third internal power supply terminal 503, and the other terminal is connected to third internal ground terminal 513.

One terminal of fourth bypass capacitor 604b is connected to fourth internal power supply terminal 504, and the other terminal is connected to fourth internal ground terminal 514.

Here, the difference in length between each of the following four electrical paths is less than or equal to 3 mm: (1) the electrical path from first bypass capacitor 601b to first internal power supply terminal 501; (2) the electrical path from second bypass capacitor 602b to second internal power supply terminal 502; (3) the electrical path from third bypass capacitor 603b to third internal power supply terminal 503; and (4) the electrical path from fourth bypass capacitor 604b to fourth internal power supply terminal 504. At this time, the difference in inductance between each of these four electrical paths is less than or equal to 2 nH.

[Observations]

As described above, in module 1000b configured as described above, the difference in length between each of the above-mentioned four electrical paths is less than or equal to 3 mm, and the difference in inductance between each of these four electrical paths is less than or equal to 2 nH.

Accordingly, similar to module 1000 according to Embodiment 2, accurate depth measurement can be performed with module 1000b configured as described above.

[Variation 8]

Hereinafter, a module according to Variation 8 configured by modifying a part of module 1000 according to Embodiment 2 will be described.

Hereinafter, regarding the module according to Variation 8, the same reference numerals are assigned and detailed explanations are omitted for elements that are the same as those in module 1000 as they have already been described, and the explanation will focus on the differences from module 1000.

[Configuration]

FIG. 25 is a schematic plan view illustrating a configuration of module 1000c according to Variation 8.

As illustrated in FIG. 25, module 1000c is configured by modifying module 1000 according to Embodiment 2 such that depth imaging device 30 is changed to depth imaging device 300.

[Observations]

Similar to module 1000 according to Embodiment 2, in module 1000 configured as described above, the difference in length between each of the following four electrical paths is less than or equal to 3 mm: (1) the electrical path from first bypass capacitor 601 to first internal power supply terminal 501; (2) the electrical path from first bypass capacitor 601 to third internal power supply terminal 503; (3) the electrical path from second bypass capacitor 602 to second internal power supply terminal 502; and (4) the electrical path from second bypass capacitor 602 to fourth internal power supply terminal 504. At this time, the difference in inductance between each of these four electrical paths is less than or equal to 2 nH.

Accordingly, similar to module 1000 according to Embodiment 2, accurate depth measurement can be performed with module 1000c configured as described above.

[Variation 9]

Hereinafter, a module according to Variation 9 configured by modifying a part of module 1000a according to Variation 6 will be described.

Hereinafter, regarding the module according to Variation 9, the same reference numerals are assigned and detailed explanations are omitted for elements that are the same as those in module 1000a as they have already been described, and the explanation will focus on the differences from module 1000a.

[Configuration]

FIG. 26 is a schematic plan view illustrating a configuration of module 1000d according to Variation 9.
As illustrated in FIG. 26, module 1000d is configured by modifying module 1000a according to Variation 6 such that depth imaging device 30a is changed to depth imaging device 300a.

[Observations]

Similar to module 1000a according to Variation 6, in module 1000d configured as described above, the difference in length between each of the following eighty four electrical paths is less than or equal to 3 mm: (1) the electrical path from first bypass capacitor 601a to first internal power supply terminal 501a; (2) the electrical path from first bypass capacitor 601a to second internal power supply terminal 502a; (3) the electrical path from second bypass capacitor 602a to third internal power supply terminal 503a; and (4) the electrical path from second bypass capacitor 602a to fourth internal power supply terminal 504a. At this time, the difference in inductance between each of these four electrical paths is less than or equal to 2 nH.
Accordingly, similar to module 1000a according to Variation 6, accurate depth measurement can be performed with module 1000d configured as described above.

[Variation 10]

Hereinafter, a module according to Variation 10 configured by modifying a part of module 1000b according to Variation 7 will be described.
Hereinafter, regarding the module according to Variation 10, the same reference numerals are assigned and detailed explanations are omitted for elements that are the same as those in module 1000b as they have already been described, and the explanation will focus on the differences from module 1000b.

[Configuration]

FIG. 27 is a schematic plan view illustrating a configuration of module 1000e according to Variation 10.
As illustrated in FIG. 27, module 1000e is configured by modifying module 1000b according to Variation 7 such that depth imaging device 30 is changed to depth imaging device 300.

[Observations]

Similar to module 1000b according to Variation 7, in module 1000e configured as described above, the difference in length between each of the following four electrical paths is less than or equal to 3 mm: (1) the electrical path from first bypass capacitor 601b to first internal power supply terminal 501; (2) the electrical path from second bypass capacitor 602b to second internal power supply terminal 502; (3) the electrical path from third bypass capacitor 603b to third internal power supply terminal 503; and (4) the electrical path from fourth bypass capacitor 604b to fourth internal power supply terminal 504. At this time, the difference in inductance between each of these four electrical paths is less than or equal to 2 nH.
Accordingly, similar to module 1000b according to Variation 7, accurate depth measurement can be performed with module 1000e configured as described above.

(Supplementary Notes)

Although a depth imaging device, a package, a module, and a depth imaging system according to one aspect of the present disclosure have been described based on Embodiment 1 to Embodiment 2 and Variation 1 to Variation 10, the present disclosure is not limited to these Embodiments and Variations. Other embodiments obtained by various modifications of these embodiments and variations that may be conceived by persons skilled in the art, as well as embodiments resulting from combinations of elements from different embodiments and variations that do not depart from the essence of the present disclosure may be also included in the scope of one or more aspects of the present disclosure.
(1) In Embodiment 1, FIG. 4 is presented as an example of a timing chart illustrating operation of pixel 40 during exposure, but the present disclosure is not limited to this.

FIG. 28 is a timing chart illustrating another example of operation of pixel 40 during exposure.
For example, as illustrated in the timing chart in FIG. 28, the delay amount of the reflected light may be detected by complementarily and continuously operating the first drive signal and the second drive signal that drive first readout gate 6a and second readout gate 6b included in pixel 40. In this case as well, according to this Embodiment 1, it is possible to measure depth with higher accuracy.
(2) The package disclosed in Embodiment 1 and Variations 1 to 5 is not limited to specific packages such as ceramic packages, resin-sealed packages, or chip-scale packages (CSP).

(3) The module disclosed in Embodiment 2 and Variations 6 to 10 may further include a package such as a ceramic package, a resin-sealed package, or a chip-scale package (CSP). Even in this case, by maintaining electrical symmetry from the internal terminals to the bypass capacitors of the package, accurate depth measurement can be performed in the module embodiment as well.

(4) In Embodiment 1, FIG. 6 is exemplified as a configuration of package 100, but the present disclosure is not limited to this.

FIG. 29 is a schematic plan view illustrating another example of a configuration of package 100.

For example, as illustrated in FIG. 29, each power supply terminal and each ground terminal, as well as each internal power supply terminal and each internal ground terminal, may be divided into a plurality of terminals.

This technique is a method generally used to increase the available current, and in this case as well, according to this embodiment, it is possible to measure depth with higher accuracy.

[Industrial Applicability]

The present disclosure is widely applicable to depth imaging devices, packages, modules, and depth imaging systems.

[Reference Signs List]

1 photoelectric converter
2 charge accumulator
2a first charge accumulator
2b second charge accumulator
4 transfer channel
5, 5a, 5b, 5c, 5d, 5e transfer electrode
6 readout gate
6a first readout gate (first gate electrode)
6b second readout gate (second gate electrode)
8, 8a, 8b exposure control gate (third gate electrode)
9, 9a, 9b overflow drain
10 charge holder
11 charge holding gate
12 transfer control gate
13 output control gate
14 floating diffusion layer
15 reset gate
16 reset drain
17 readout circuit
30, 30a, 300, 300a depth imaging device
31, 32, 33 semiconductor chip
40 pixel
41 pixel array

50a first driving element group
50b second driving element group
51 first driver
51a first driving element
51b second driving element
51aa, 51ba, 52aa, 52ba, 53aa, 53ba circuit
52 second driver
52a third driving element
52b fourth driving element
53 third driver
53a fifth driving element
53b sixth driving element
61 first delay adjustment circuit
62 second delay adjustment circuit
63 third delay adjustment circuit
70 control signal output circuit
71 first power supply terminal
72 second power supply terminal
73 third power supply terminal
74 fourth power supply terminal
81, 81a first ground terminal
82, 82a second ground terminal
83, 83a third ground terminal
84, 84a fourth ground terminal
91, 92 power supply wiring
96, 97 ground wiring
100, 100a, 100b, 100c, 100d, 100e package
101, 101a, 501, 501a first internal power supply terminal
102, 102a, 502, 502a second internal power supply terminal
103, 103a, 503, 503a third internal power supply terminal
104, 104a, 504, 504a fourth internal power supply terminal
110 light source
111, 111a, 511, 511a first internal ground terminal
112, 112a, 512, 512a second internal ground terminal
113, 113a, 513, 513a third internal ground terminal
114, 114a, 514, 514a fourth internal ground terminal
120 signal processing device
130 subject
200, 200a depth imaging system
201, 201a, 201b first external power supply terminal
202, 202a, 202b second external power supply terminal
203b third external power supply terminal
204b fourth external power supply terminal
211, 211a, 211b first external ground terminal
212, 212a, 212b second external ground terminal
213b third external ground terminal
214b fourth external ground terminal
500, 500a, 500b, 500c, 500d, 500e mounting substrate
601, 601a, 601b first bypass capacitor
602, 602a, 602b second bypass capacitor
603b third bypass capacitor

604b fourth bypass capacitor
1000, 1000a, 1000b, 1000c, 1000d, 1000e module

**Claims**

1. A depth imaging device for measuring depth using an indirect time of flight (TOF) method, the depth imaging device comprising:

   a pixel array in which a plurality of pixels are arranged in an array, each of the plurality of pixels including a photoelectric converter that converts received light into charge, and a plurality of gate electrodes for transferring the charge generated by the photoelectric converter;
   a control signal output circuit that outputs a plurality of control signals that control the plurality of gate electrodes of the plurality of pixels;
   a plurality of delay adjustment circuits that adjust a delay time of each of the plurality of control signals and output a plurality of delayed control signals with adjusted delay times;
   a plurality of drivers that receive input of the plurality of delayed control signals and output a plurality of drive signals that drive the plurality of gate electrodes of the plurality of pixels;
   a plurality of power supply wirings that supply a power supply potential to the plurality of drivers; and
   a plurality of ground wirings that supply a ground potential to the plurality of drivers, wherein
   the plurality of power supply wirings include a common portion with each other,
   the plurality of ground wirings include a common portion with each other, and
   the plurality of delay adjustment circuits adjust the delay times of the plurality of control signals to make respective phase differences between the plurality of control signals and the plurality of drive signals constant.

2. The depth imaging device according to claim 1, wherein

   the plurality of gate electrodes include a first gate electrode and a second gate electrode,
   the plurality of control signals include a first control signal that controls the first gate electrodes of the plurality of pixels, and a second control signal that controls the second gate electrodes of the plurality of pixels,
   the plurality of delayed control signals include a first delayed control signal and a second delayed control signal,
   the plurality of delay adjustment circuits include a first delay adjustment circuit that adjusts a delay time of the first control signal and outputs the first delayed control signal with an adjusted delay time, and a second delay adjustment circuit that adjusts a delay time of the second control signal and outputs the second delayed control signal with an adjusted delay time,
   the plurality of drive signals include a first drive signal and a second drive signal,
   the plurality of drivers include a first driver that receives input of the first delayed control signal and outputs the first drive signal that drives the first gate electrodes of the plurality of pixels, and a second driver that receives input of the second delayed control signal and outputs the second drive signal that drives the second gate electrodes of the plurality of pixels,
   the plurality of power supply wirings include first power supply wiring that supplies the power supply potential to the first driver, and second power supply wiring that supplies the power supply potential to the second driver,
   the plurality of ground wirings include first ground wiring that supplies the ground potential to the first driver, and second ground wiring that supplies the ground potential to the second driver,
   the first power supply wiring and the second power supply wiring include a common portion,
   the first ground wiring and the second ground wiring include a common portion,
   the first delay adjustment circuit adjusts the delay time of the first control signal to make a phase difference between the first control signal and the first drive signal constant, and
   the second delay adjustment circuit adjusts the delay time of the second control signal to make a phase difference between the second control signal and the second drive signal constant.

3. The depth imaging device according to claim 2, wherein

   each of the plurality of pixels further includes a third gate electrode for discharging the charge generated by the photoelectric converter,
   the control signal output circuit further outputs a third control signal that controls the third gate electrodes of the plurality of pixels,
   the depth imaging device further comprises:

      a third delay adjustment circuit that adjusts a delay time of the third control signal and outputs a third delayed control signal with an adjusted delay time; and
      a third driver that receives input of the third delayed control signal and outputs a third drive signal that drives the third gate electrodes of the plurality of pixels, and

the third delay adjustment circuit adjusts the delay time of the third control signal to make a phase difference between the third control signal and the third drive signal constant.

4. The depth imaging device according to claim 2 or 3, wherein
the control signal output circuit outputs the first control signal including a pulse with a pulse width of 10 ns or less and the second control signal including a pulse with a pulse width of 10 ns or less.

5. The depth imaging device according to any one of claims 2 to 4, wherein
the depth imaging device is configured as:

a single semiconductor chip on which the pixel array, the first driver, and the second driver are formed; or
a first semiconductor chip on which the pixel array is formed and a second semiconductor chip on which the first driver and the second driver are formed, the first semiconductor chip and the second semiconductor chip being stacked on each other.

6. A package comprising:

the depth imaging device according to any one of claims 2 to 5, wherein
the first driver includes a first driving element and a second driving element arranged in positions opposing each other and sandwiching the pixel array in a first direction in a plan view of the depth imaging device,
the depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element,
the first power supply terminal and the second power supply terminal are arranged in positions opposing each other and sandwiching the first driving element in a second direction orthogonal to the first direction in the plan view of the depth imaging device,
the third power supply terminal and the fourth power supply terminal are arranged in positions opposing each other and sandwiching the second driving element in the second direction in the plan view of the depth imaging device,

the first ground terminal and the second ground terminal are arranged in positions opposing each other and sandwiching the first driving element in the second direction in the plan view of the depth imaging device,
the third ground terminal and the fourth ground terminal are arranged in positions opposing each other and sandwiching the second driving element in the second direction in the plan view of the depth imaging device,
the package further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to a first set of two internal power supply terminals from among the first internal power supply terminal, the second internal power supply terminal, the third internal power supply terminal, and the fourth internal power supply terminal; and a second external power supply terminal connected to a second set of two internal power supply terminals not included in the first set from among the first internal power supply terminal, the second internal power supply terminal, the third internal power supply terminal, and the fourth internal power supply terminal, and
a difference in length between each of the following four electrical paths is less than or equal to 3 mm, or a difference in inductance between each of the following four electrical paths is less than or equal to 2 nH: (1) an electrical path from the first external power supply terminal to one internal power supply terminal in the first set; (2) an electrical path from the first external power supply terminal to an other internal power supply terminal in the first set; (3) an electrical path from the second external power supply terminal to one internal power supply terminal in the second set; and (4) an electrical path from the second external power supply terminal to an other internal power supply terminal in the second set.

7. A package comprising:

the depth imaging device according to any one of claims 2 to 5, wherein
the first driver includes a first driving element and a second driving element arranged in positions opposing each other and sandwiching the pixel array in a first direction in a plan view of the depth imaging device,
the depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element,

the first power supply terminal and the second power supply terminal are arranged in positions opposing each other and sandwiching the first driving element in a second direction orthogonal to the first direction in the plan view of the depth imaging device,

the third power supply terminal and the fourth power supply terminal are arranged in positions opposing each other and sandwiching the second driving element in the second direction in the plan view of the depth imaging device,

the first ground terminal and the second ground terminal are arranged in positions opposing each other and sandwiching the first driving element in the second direction in the plan view of the depth imaging device,

the third ground terminal and the fourth ground terminal are arranged in positions opposing each other and sandwiching the second driving element in the second direction in the plan view of the depth imaging device,

the package further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to the first internal power supply terminal; a second external power supply terminal connected to the second internal power supply terminal; a third external power supply terminal connected to the third internal power supply terminal; and a fourth external power supply terminal connected to the fourth internal power supply terminal, and

a difference in length between each of the following four electrical paths is less than or equal to 3 mm, or a difference in inductance between each of the following four electrical paths is less than or equal to 2 nH: (1) an electrical path from the first external power supply terminal to the first internal power supply terminal; (2) an electrical path from the second external power supply terminal to the second internal power supply terminal; (3) an electrical path from the third external power supply terminal to the third internal power supply terminal; and (4) an electrical path from the fourth external power supply terminal to the fourth internal power supply terminal.

8.  A module comprising:

    the depth imaging device according to any one of claims 2 to 5; and
    a mounting substrate on which the depth imaging device is mounted, wherein
    the first driver includes a first driving element and a second driving element arranged in positions opposing each other and sandwiching the pixel array in a first direction in a plan view of the depth imaging device,
    the depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element,
    the first power supply terminal and the second power supply terminal are arranged in positions opposing each other and sandwiching the first driving element in a second direction orthogonal to the first direction in the plan view of the depth imaging device,
    the third power supply terminal and the fourth power supply terminal are arranged in positions opposing each other and sandwiching the second driving element in the second direction in the plan view of the depth imaging device,
    the first ground terminal and the second ground terminal are arranged in positions opposing each other and sandwiching the first driving element in the second direction in the plan view of the depth imaging device,
    the third ground terminal and the fourth ground terminal are arranged in positions opposing each other and sandwiching the second driving element in the second direction in the plan view of the depth imaging device,
    the mounting substrate further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to a first set of two internal power supply terminals from among the first internal power supply terminal, the second internal power supply terminal, the third internal power supply terminal, and the fourth internal power supply terminal; and a second bypass capacitor including one terminal connected to a second set of two internal power supply terminals not included in the first set from among the first internal power supply terminal, the second internal power supply terminal, the third internal power supply terminal, and the fourth internal power supply terminal, and

a difference in length between each of the following four electrical paths is less than or equal to 3 mm, or a difference in inductance between each of the following four electrical paths is less than or equal to 2 nH: (1) an electrical path from the first bypass capacitor to one internal power supply terminal in the first set; (2) an electrical path from the first bypass capacitor to an other internal power supply terminal in the first set; (3) an electrical path from the second bypass capacitor to one internal power supply terminal in the second set; and (4) an electrical path from the second bypass capacitor to an other internal power supply terminal in the second set.

9. A module comprising:

the depth imaging device according to any one of claims 2 to 5; and
a mounting substrate on which the depth imaging device is mounted, wherein
the first driver includes a first driving element and a second driving element arranged in positions opposing each other and sandwiching the pixel array in a first direction in a plan view of the depth imaging device,
the depth imaging device includes: a first power supply terminal and a second power supply terminal that supply the power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element,
the first power supply terminal and the second power supply terminal are arranged in positions opposing each other and sandwiching the first driving element in a second direction orthogonal to the first direction in the plan view of the depth imaging device,
the third power supply terminal and the fourth power supply terminal are arranged in positions opposing each other and sandwiching the second driving element in the second direction in the plan view of the depth imaging device,
the first ground terminal and the second ground terminal are arranged in positions opposing each other and sandwiching the first driving element in the second direction in the plan view of the depth imaging device,
the third ground terminal and the fourth ground terminal are arranged in positions opposing each other and sandwiching the second driving element in the second direction in the plan view of the depth imaging device,
the mounting substrate further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to the first internal power supply terminal; a second bypass capacitor including one terminal connected to the second internal power supply terminal; a third bypass capacitor including one terminal connected to the third internal power supply terminal; and a fourth bypass capacitor including one terminal connected to the fourth internal power supply terminal, and
a difference in length between each of the following four electrical paths is less than or equal to 3 mm, or a difference in inductance between each of the following four electrical paths is less than or equal to 2 nH: (1) an electrical path from the first bypass capacitor to the first internal power supply terminal; (2) an electrical path from the second bypass capacitor to the second internal power supply terminal; (3) an electrical path from the third bypass capacitor to the third internal power supply terminal; and (4) an electrical path from the fourth bypass capacitor to the fourth internal power supply terminal.

10. A package comprising:

a depth imaging device for measuring depth using an indirect time of flight (TOF) method, wherein
the depth imaging device includes:

a pixel array in which a plurality of pixels are arranged in an array, each of the plurality of pixels including a photoelectric converter that converts received light into charge, and a first gate electrode and a second gate electrode for transferring the charge generated by the photoelectric converter;
a control signal output circuit that outputs a first control signal that controls the first gate electrodes of the plurality of pixels, and a second control signal that controls the second gate electrodes of the plurality of pixels;
a first driver that outputs a first drive signal that drives the first gate electrodes of the plurality of pixels based on the first control signal;
a second driver that outputs a second drive signal that drives the second gate electrodes of the plurality of pixels based on the second control signal;
first power supply wiring that supplies power to the first driver;
second power supply wiring that supplies power to the second driver;
first ground wiring that supplies a ground potential to the first driver; and
second ground wiring that supplies the ground potential to the second driver,

the first power supply wiring and the second power supply wiring include a common part,
the first ground wiring and the second ground wiring include a common portion,
the first driver includes a first driving element and a second driving element arranged in positions opposing each other and sandwiching the pixel array in a first direction in a plan view of the depth imaging device,
the depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element,
the first power supply terminal and the second power supply terminal are arranged in positions opposing each other and sandwiching the first driving element in a second direction orthogonal to the first direction in the plan view of the depth imaging device,
the third power supply terminal and the fourth power supply terminal are arranged in positions opposing each other and sandwiching the second driving element in the second direction in the plan view of the depth imaging device,
the first ground terminal and the second ground terminal are arranged in positions opposing each other and sandwiching the first driving element in the second direction in the plan view of the depth imaging device,
the third ground terminal and the fourth ground terminal are arranged in positions opposing each other and sandwiching the second driving element in the second direction in the plan view of the depth imaging device,
the package further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to a first set of two internal power supply terminals from among the first internal power supply terminal, the second internal power supply terminal, the third internal power supply terminal, and the fourth internal power supply terminal; and a second external power supply terminal connected to a second set of two internal power supply terminals not included in the first set from among the first internal power supply terminal, the second internal power supply terminal, the third internal power supply terminal, and the fourth internal power supply terminal, and
a difference in length between each of the following four electrical paths is less than or equal to 3 mm, or a difference in inductance between each of the following four electrical paths is less than or equal to 2 nH: (1) an electrical path from the first external power supply terminal to one internal power supply terminal in the first set; (2) an electrical path from the first external power supply terminal to an other internal power supply terminal in the first set; (3) an electrical path from the second external power supply terminal to one internal power supply terminal in the second set; and (4) an electrical path from the second external power supply terminal to an other internal power supply terminal in the second set.

11. A package comprising:

a depth imaging device for measuring depth using an indirect time of flight (TOF) method, wherein
the depth imaging device includes:

a pixel array in which a plurality of pixels are arranged in an array, each of the plurality of pixels including a photoelectric converter that converts received light into charge, and a first gate electrode and a second gate electrode for transferring the charge generated by the photoelectric converter;

a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal; a second driver that outputs a second drive signal that drives the second gate electrodes of the plurality of pixels based on the second control signal; first power supply wiring that supplies power to the first driver; second power supply wiring that supplies power to the second driver; first ground wiring that supplies a ground potential to the first driver; and second ground wiring that supplies the ground potential to the second driver,

the first power supply wiring and the second power supply wiring include a common part, the first ground wiring and the second ground wiring include a common portion, the first driver includes a first driving element and a second driving element arranged in positions opposing each other and sandwiching the pixel array in a first direction in a plan view of the depth imaging device, the depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element, the first power supply terminal and the second power supply terminal are arranged in positions opposing each other and sandwiching the first driving element in a second direction orthogonal to the first direction in the plan view of the depth imaging device, the third power supply terminal and the fourth power supply terminal are arranged in positions opposing each other and sandwiching the second driving element in the second direction in the plan view of the depth imaging device, the first ground terminal and the second ground terminal are arranged in positions opposing each other and sandwiching the first driving element in the second direction in the plan view of the depth imaging device, the third ground terminal and the fourth ground terminal are arranged in positions opposing each other and sandwiching the second driving element in the second direction in the plan view of the depth imaging device, the package further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first external power supply terminal connected to the first internal power supply terminal; a second external power supply terminal connected to the second internal power supply terminal; a third external power supply terminal connected to the third internal power supply terminal; and a fourth external power supply terminal connected to the fourth internal power supply terminal, and a difference in length between each of the following four electrical paths is less than or equal to 3 mm, or a difference in inductance between each of the following four electrical paths is less than or equal to 2 nH: (1) an electrical path from the first external power supply terminal to the first internal power supply terminal; (2) an electrical path from the second external power supply terminal to the second internal power supply terminal; (3) an electrical path from the third external power supply terminal to the third internal power supply terminal; and (4) an electrical path from the fourth external power supply terminal to the fourth internal power supply terminal.

12. A module comprising:

a depth imaging device for measuring depth using an indirect time of flight (TOF) method; and a mounting substrate on which the depth imaging device is mounted, wherein the depth imaging device includes:

a pixel array in which a plurality of pixels are arranged in an array, each of the plurality of pixels including a photoelectric converter that converts received light into charge, and a first gate electrode and a second gate electrode for transferring the charge generated by the photoelectric converter; a control signal output circuit that outputs a first control signal that controls the first gate electrodes of the plurality of pixels, and a second control signal that controls the second gate electrodes of the plurality of pixels; a first driver that outputs a first drive signal that drives the first gate electrodes of the plurality of pixels based on the first control signal;

a second driver that outputs a second drive signal that drives the second gate electrodes of the plurality of pixels based on the second control signal;

first power supply wiring that supplies power to the first driver;

second power supply wiring that supplies power to the second driver;

first ground wiring that supplies a ground potential to the first driver; and

second ground wiring that supplies the ground potential to the second driver,

the first power supply wiring and the second power supply wiring include a common part,

the first ground wiring and the second ground wiring include a common portion,

the first driver includes a first driving element and a second driving element arranged in positions opposing each other and sandwiching the pixel array in a first direction in a plan view of the depth imaging device,

the depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element,

the first power supply terminal and the second power supply terminal are arranged in positions opposing each other and sandwiching the first driving element in a second direction orthogonal to the first direction in the plan view of the depth imaging device,

the third power supply terminal and the fourth power supply terminal are arranged in positions opposing each other and sandwiching the second driving element in the second direction in the plan view of the depth imaging device,

the first ground terminal and the second ground terminal are arranged in positions opposing each other and sandwiching the first driving element in the second direction in the plan view of the depth imaging device,

the third ground terminal and the fourth ground terminal are arranged in positions opposing each other and sandwiching the second driving element in the second direction in the plan view of the depth imaging device,

the mounting substrate further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to a first set of two internal power supply terminals from among the first internal power supply terminal, the second internal power supply terminal, the third internal power supply terminal, and the fourth internal power supply terminal; and a second bypass capacitor including one terminal connected to a second set of two internal power supply terminals not included in the first set from among the first internal power supply terminal, the second internal power supply terminal, the third internal power supply terminal, and the fourth internal power supply terminal, and

a difference in length between each of the following four electrical paths is less than or equal to 3 mm, or a difference in inductance between each of the following four electrical paths is less than or equal to 2 nH: (1) an electrical path from the first bypass capacitor to one internal power supply terminal in the first set; (2) an electrical path from the first bypass capacitor to an other internal power supply terminal in the first set; (3) an electrical path from the second bypass capacitor to one internal power supply terminal in the second set; and (4) an electrical path from the second bypass capacitor to an other internal power supply terminal in the second set.

13. A module comprising:

a depth imaging device for measuring depth using an indirect time of flight (TOF) method; and
a mounting substrate on which the depth imaging device is mounted, wherein
the depth imaging device includes:

a pixel array in which a plurality of pixels are arranged in an array, each of the plurality of pixels including a photoelectric converter that converts received light into charge, and a first gate electrode and a second gate electrode for transferring the charge generated by the photoelectric converter;
a control signal output circuit that outputs a first control signal that controls the first gate electrodes of the plurality of pixels, and a second control signal that controls the second gate electrodes of the plurality of pixels;
a first driver that outputs a first drive signal that drives the first gate electrodes of the plurality of pixels based on the first control signal;
a second driver that outputs a second drive signal that drives the second gate electrodes of the plurality of pixels based on the second control signal;
first power supply wiring that supplies power to the first driver;
second power supply wiring that supplies power to the second driver;
first ground wiring that supplies a ground potential to the first driver; and
second ground wiring that supplies the ground potential to the second driver,

the first power supply wiring and the second power supply wiring include a common part,
the first ground wiring and the second ground wiring include a common portion,
the first driver includes a first driving element and a second driving element arranged in positions opposing each other and sandwiching the pixel array in a first direction in a plan view of the depth imaging device,
the depth imaging device includes: a first power supply terminal and a second power supply terminal that supply a power supply potential to the first driving element; a third power supply terminal and a fourth power supply terminal that supply the power supply potential to the second driving element; a first ground terminal and a second ground terminal that supply the ground potential to the first driving element; and a third ground terminal and a fourth ground terminal that supply the ground potential to the second driving element,
the first power supply terminal and the second power supply terminal are arranged in positions opposing each other and sandwiching the first driving element in a second direction orthogonal to the first direction in the plan view of the depth imaging device,
the third power supply terminal and the fourth power supply terminal are arranged in positions opposing each other and sandwiching the second driving element in the second direction in the plan view of the depth imaging device,
the first ground terminal and the second ground terminal are arranged in positions opposing each other and sandwiching the first driving element in the second direction in the plan view of the depth imaging device,
the third ground terminal and the fourth ground terminal are arranged in positions opposing each other and sandwiching the second driving element in the second direction in the plan view of the depth imaging device,

the mounting substrate further comprises: a first internal power supply terminal connected to the first power supply terminal; a second internal power supply terminal connected to the second power supply terminal; a third internal power supply terminal connected to the third power supply terminal; a fourth internal power supply terminal connected to the fourth power supply terminal; a first bypass capacitor including one terminal connected to the first internal power supply terminal; a second bypass capacitor including one terminal connected to the second internal power supply terminal; a third bypass capacitor including one terminal connected to the third internal power supply terminal; and a fourth bypass capacitor including one terminal connected to the fourth internal power supply terminal, and
a difference in length between each of the following four electrical paths is less than or equal to 3 mm, or a difference in inductance between each of the following four electrical paths is less than or equal to 2 nH: (1) an electrical path from the first bypass capacitor to the first internal power supply terminal; (2) an electrical path from the second bypass capacitor to the second internal power supply terminal; (3) an electrical path from the third bypass capacitor to the third internal power supply terminal; and (4) an electrical path from the fourth bypass capacitor to the fourth internal power supply terminal.

14. A depth imaging system comprising:

the depth imaging device according to any one of claims 2 to 5;
the package according to any one of claims 6, 7, 10, or 11; or
the module according to any one of claims 8, 9, 12, or 13.

# FIG. 1

EP 4 503 643 A1

# FIG. 2

EP 4 503 643 A1

Depth imaging device — 30

71 91 / 72
81 96 / 82

50a — First driving element group

Third driver (fifth driving element) — 53 (53a)
Second driver (third driving element) — 52 (52a)
First driver (first driving element) — 51 (51a)

41
40

61 — First delay adjustment circuit
62 — Second delay adjustment circuit
63 — Third delay adjustment circuit
70 — Control signal output circuit

First driver (second driving element) — 51 (51b)
Second driver (fourth driving element) — 52 (52b)
Third driver (sixth driving element) — 53 (53b)

83 97 / 84
73 92 / 74

Second driving element group — 50b

To light source 110

# FIG. 3

## FIG. 4

# FIG. 5

# FIG. 6

FIG. 7

EP 4 503 643 A1

## FIG. 8

(a)

(b)

## FIG. 9

## FIG. 10

# FIG. 11

Changes due to temperature

Delay time

Upper — Central — Lower

Position in column direction

# FIG. 12

Delay time

8 nsec

5 nsec

Lower — Central — Upper

Position in column direction

# FIG. 13

# FIG. 14

# FIG. 15A

# FIG. 15B

# FIG. 15C

FIG. 16

# FIG. 17

FIG. 18

FIG. 19

100d

201a  211a

101a  111a          112a  102a

                                300a

Depth imaging device

71  81a          82a  72

73  83a          84a  74

103a  113a          114a  104a

202a  212a

Y
Z  X

FIG. 20

## FIG. 21

# FIG. 22

# FIG. 23

# FIG. 24

1000b

500b
Mounting substrate

601b  501          30    502  602b
71   Depth imaging device  72
81                          82
511                         512

603b  513                   514  604b
83                          84
73                          74
503                         504

y
z ⊙ → x

# FIG. 25

EP 4 503 643 A1

FIG. 26

60

## FIG. 27

FIG. 28

FIG. 29

## INTERNATIONAL SEARCH REPORT

International application No.

**PCT/JP2023/010993**

### A. CLASSIFICATION OF SUBJECT MATTER

*H04N 25/705*(2023.01)i; *G01S 7/481*(2006.01)i; *G01S 17/894*(2020.01)i
FI: H04N25/705; G01S17/894; G01S7/481 A

According to International Patent Classification (IPC) or to both national classification and IPC

### B. FIELDS SEARCHED

Minimum documentation searched (classification system followed by classification symbols)

H04N25/705; G01S7/481; G01S17/894

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2021/172364 A1 (NUVOTON TECHNOLOGY CORP. JAPAN) 02 September 2021 (2021-09-02)<br>  paragraphs [0013]-[0026], fig. 1 | 1-14 |
| A | WO 2020/129954 A1 (PANASONIC SEMICONDUCTOR SOLUTIONS CO., LTD.) 25 June 2020 (2020-06-25)<br>  paragraphs [0026]-[0036], fig. 1 | 1-14 |
| A | JP 2019-75826 A (PANASONIC INTELLECTUAL PROPERTY MANAGEMENT CO., LTD.) 16 May 2019 (2019-05-16)<br>  paragraphs [0019]-[0031], fig. 1 | 1-14 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 May 2023** | **30 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

<table>
<thead>
<tr><th colspan="2" align="center">INTERNATIONAL SEARCH REPORT<br>Information on patent family members</th><th align="left">International application No.<br><br>**PCT/JP2023/010993**</th></tr>
</thead>
</table>

| Patent document cited in search report | Publication date (day/month/year) | Patent family member(s) | Publication date (day/month/year) |
|---|---|---|---|
| WO 2021/172364 A1 | 02 September 2021 | US 2022/0408048 A1<br>paragraphs [0025]-[0038], fig. 1<br>CN 115152202 A | |
| WO 2020/129954 A1 | 25 June 2020 | US 2021/0302547 A1<br>paragraphs [0040]-[0050], fig. 1<br>CN 113242957 A | |
| JP 2019-75826 A | 16 May 2019 | US 2020/0213540 A1<br>paragraphs [0032]-[0043], fig. 1<br>WO 2019/054099 A1<br>CN 111034177 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020129954 A
- JP 2019075826 A
- JP 2020085464 A